# EUROPEAN PATENT APPLICATION

(11) **EP 4 516 738 A1**
(43) Date of publication of application: **05.03.2025**
(21) Application number: 23796525.6
(22) Date of filing: 27.04.2023
(51) Int. Cl.: C01B 39/48, C08K 3/34, C08K 7/18, C08L 63/00, C08L 79/08, C08L 101/00, H01L 23/29, H01L 23/31

(54) **ZEOLITE, METHOD FOR PRODUCING ZEOLITE, COMPOSITION, LIQUID SEALING AGENT, RESIN COMPOSITE MATERIAL, SEALING MATERIAL, METHOD FOR PRODUCING SEALING MATERIAL, AND ELECTRONIC DEVICE**

(30) Priority: 28.04.2022 JP 2022075120
(71) Applicant: Mitsubishi Chemical Corporation, Tokyo 100-8251 (JP)
(72) Inventor: OHNISHI, Ryohji, Tokyo 100-8251 (JP); NAKANO MATSUNAGA, Chie, Tokyo 100-8251 (JP); KATAGIRI, Noriko, Tokyo 100-8251 (JP); MATSUI, Jun, Tokyo 100-8251 (JP); TAKEWAKI, Takahiko, Tokyo 100-8251 (JP)
(74) Representative: Hoffmann Eitle
(86) International application number: PCT/JP2023/016775
(87) International publication number: WO 2023/210790

(57) **Abstract**

The present invention provides a zeolite which is a spherical aluminosilicate having a particle size of 0.05 µm or more and less than 1.0 µm and having d6r as CBU. A zeolite having a small thermal expansion coefficient can be provided.

## Description

### Technical Field

The present invention relates to a zeolite, a method for producing a zeolite, a composition, a liquid sealing agent, a resin composite material, a sealing material, a method for producing a sealing material, and an electronic device.

### Background Art

A liquid sealing agent used as an underfill material is required to be excellent in injectability, adhesiveness, curability, storage stability, and the like, and not to generate voids. In addition, a portion sealed with the liquid sealing agent is required to be excellent in moisture resistance, thermal cycle resistance, reflow resistance, crack resistance, warpage resistance, and the like. In order to satisfy the above requirements, a liquid sealing agent containing an epoxy resin as a main ingredient has been widely used as a liquid sealing agent used as the underfill material.

In addition, in order to improve the moisture resistance and the thermal cycle resistance of the portion sealed by the liquid sealing agent, in particular, the thermal cycle resistance, it is known that by using a filling material made of an inorganic substance such as a silica filler (hereinafter referred to as an "inorganic filler") as the liquid sealing agent, it is effective to control a difference in thermal expansion coefficient between a substrate made of an organic material such as an epoxy resin and a semiconductor element or to reinforce a bump electrode (see PTL 1).

### Citation List

### Patent Literature

PTL 1: JP 2007-56070 A

### Summary of Invention

### Technical Problem

A liquid sealing agent using an inorganic filler such as a silica filler does not have a sufficiently low thermal expansion coefficient, and from the viewpoint of thermal cycle resistance, it is required to further lower the thermal expansion coefficient. In addition, a zeolite is known as an inorganic filler having a low thermal expansion coefficient, but a liquid composition in which the zeolite is blended tends to have a high viscosity, and the injectability when used as an underfill material is reduced, and therefore, it is difficult to obtain a liquid sealing agent having good injectability while lowering the thermal expansion coefficient of a cured product.

In addition, in the case of an application of a liquid sealing agent for filling a gap of about several tens of µm such as an underfill material for narrow gap, if the particle size of the inorganic filler is too large, the liquid composition does not spread in the gap by the inorganic filler, and cannot be sufficiently filled in a desired gap, and thus voids may be formed.

In general, it is said that when voids are formed in the filling of a liquid sealing agent, solder is exposed only partially to cause solder fracture, which adversely affects reliability. Therefore, the particle size of the inorganic filler used in the liquid sealing agent is preferably less than about 1/10 of the gap width.

In the future, miniaturization of devices and miniaturization of members constituting the devices are expected to progress, and miniaturization, thinning, and 3D stacking of semiconductors chips are also expected to progress. In such an application, it is considered that mounting with a gap of about 25 µm, which is narrower than the current narrow gap of about 50 µm, is required. That is, it is necessary to develop a negative expansion filler having a small particle size which can cope with such an application.

Accordingly, an object of the present invention is to provide a composition having a low viscosity and a low thermal expansion coefficient after curing, and a resin composite material obtained by curing the composition.

Another object of the present invention is to provide a zeolite suitable for obtaining a composition having a low viscosity and a low thermal expansion coefficient after curing, and a method for producing the zeolite.

Furthermore, when a zeolite having a lower thermal expansion coefficient is used, the thermal expansion coefficient of the resin composite material can be lowered with a smaller amount, and suppression of an increase in viscosity due to the use of the zeolite can be expected. Such a zeolite having a low thermal expansion coefficient can be applied to various applications in which suppression of thermal expansion is required, such as a resin substrate. Therefore, it is also an object of the present invention to provide a zeolite having a lower thermal expansion coefficient.

### Solution to Problem

The gist of the present invention is as follows.
[1] A zeolite which is a spherical aluminosilicate having a particle size of 0.05 µm or more and less than 1.0 µm and having d6r as CBU.
[2] The zeolite as set forth in [1], having a sphericity of 0.7 or more.
[3] The zeolite as set forth in [1] or [2], which is a CHA-type zeolite.
[4] A composition containing the zeolite as set forth in any of [1] to [3] and a resin.
[5] The composition as set forth in [4], in which the resin is at least one selected from the group consisting of an epoxy resin and a polyimide resin.
[6] The composition as set forth in [4] or [5], further containing an inorganic filler having a particle size of 1.0 µm or more and 10 µm or less.
[7] The composition as set forth in any of [4] to [6], in which a content of the zeolite as set forth in any of [1] to [3] in all the fillers is 90% by mass or more.
[8] The composition as set forth in any of [4] to [7], in which the content of the zeolite is 40 to 70% by mass, the resin is an epoxy resin, and the composition has a viscosity at 23°C of 0.1 Pa·s or more and 250 Pa·s or less.
[9] A resin composite material containing the composition as set forth in any of [4] to [8], in which the content of the zeolite is 40 to 70% by mass, the resin is an epoxy resin, and an average thermal expansion coefficient at 25 to 100°C is 10 to 30 ppm/K.
[10] A liquid sealing agent containing the composition as set forth in any of [4] to [8].
[11] A sealing material containing the resin composite material as set forth in [9].
[12] An electronic device including the resin composite material as set forth in [9].
[13] A method for producing a sealing material, including a step of filling a gap with the composition as set forth in any of [4] to [8] and then curing the composition.
[14] A method for producing a zeolite, including a step of hydrothermally synthesizing a raw material composition containing a silicon atom raw material, a water-soluble aluminum atom raw material, an organic structure directing agent, a silane coupling agent, and water.
[15] The method for producing a zeolite as set forth in [14], further including a firing step.

### Advantageous Effects of Invention

According to the present invention, a composition having a low viscosity can be obtained by using a zeolite having a specific particle size, and a resin composite material having a low thermal expansion coefficient can be provided by curing the composition.

In addition, it is also possible to provide a zeolite having a low thermal expansion coefficient suitable for suppressing thermal expansion of a resin.

Furthermore, it is also possible to provide a negative expansion filler having a small particle size, which can be used in applications such as an underfill material for a narrow gap.

### Brief Description of Drawings

Fig. 1 is an SEM photograph of the zeolite of Example 1.
Fig. 2 is an SEM photograph of the zeolite of Comparative Example 1.

### Description of Embodiments

Hereinafter, the present invention will be described with reference to embodiments.

### [First Embodiment]

### <Zeolite>

The zeolite according to the first embodiment of the present invention is a spherical aluminosilicate having a particle size of 0.05 µm or more and less than 1.0 µm and having d6r as CBU. The zeolite of the present invention preferably has a high sphericity. The sphericity will be described in detail later.

### (Particle Size of Zeolite)

The particle size of the zeolite according to the first embodiment of the present invention means a diameter (circle equivalent diameter) of a circle having an area equal to a projected area of the particle and having a maximum diameter in observation of the particle with a scanning electron microscope (SEM). In the zeolite according to the first embodiment of the present invention, a plurality of zeolite particles may be aggregated to form a secondary particle. In this case, the particle size of the zeolite is the particle size of the primary particles.

The particle size of the zeolite according to the first embodiment of the present invention is preferably large from the viewpoint that when the zeolite is added to a resin, the viscosity of the resin hardly increases. On the other hand, the particle size of the zeolite is preferably small from the viewpoint that the zeolite is easily uniformly mixed with other components such as a resin and the smoothness of the surface is easily increased. Specifically, it is 0.05 µm or more, preferably 0.1 µm or more, more preferably 0.2 µm or more, particularly preferably 0.3 µm or more, and most preferably 0.4 µm or more, and on the other hand, it is less than 1.0 µm, preferably 0.9 µm or less, and more preferably 0.8 µm or less.

When the zeolite is used, it is usually used as a group of a plurality of zeolite particles instead of one zeolite particle. That is, in one aspect of the present invention, it is preferably used as a zeolite group containing at least the zeolite particle according to the first embodiment of the present invention. The average primary particle size of the zeolite in one aspect composed of such a plurality of zeolite particles is preferably in the range of 0.2 to 0.8 µm, more preferably 0.25 to 0.75 µm, and still more preferably 0.3 to 0.7 µm. The average primary particle size of the zeolite is obtained by randomly selecting 50 particles of the zeolite (powder, particles in a liquid composition or a resin composite material to be described later), measuring the particle sizes thereof, and calculating the average value thereof.

As for the volume-based particle size distribution of the zeolite, the median diameter (d50) is preferably in the range of 0.1 to 0.9 µm, more preferably in the range of 0.2 to 0.8 µm, and still more preferably in the range of 0.3 to 0.7 µm. When the median diameter is within this range, the ratio of the zeolite that exhibits the effects of the present invention is increased, and the effects of the present invention are easily obtained with a smaller amount.

### (Structure of Zeolite)

A zeolite is a compound containing silicon or aluminum and oxygen and having a TO₄ unit (T element is an element other than oxygen constituting the framework) as a basic unit. Specific examples of the zeolite include a crystalline porous aluminosilicate, a crystalline porous aluminophosphate (ALPO), or a crystalline porous silicoaluminophosphate (SAPO). The zeolite according to the first embodiment of the present invention is an aluminosilicate.

A zeolite is composed of a structural unit called Composite Building Unit (hereinafter, may be referred to as "CBU") in which several (several to several tens) TO₄ units are connected. Therefore, it has regular channels (tubular pores) and cavities.

The CBU and the crystal structure of the zeolite to be described later can be represented by a code that defines the structure of the zeolite defined by the International Zeolite Association (IZA). The structure of the zeolite can be identified by using a Zeolite Structure Database, 2018 edition (http://www.iza-structure.org/databases/) on the basis of an X-ray diffraction pattern obtained by an X-ray structure analyzer (for example, a table-top X-ray diffractometer D2 PHASER manufactured by BRUKER Corporation).

### (Framework of Zeolite)

The framework of the zeolite according to the first embodiment of the present invention has d6r as CBU. By having d6r, it is easy to obtain a resin composite material having a low thermal expansion coefficient, which will be described in detail later.

Examples of the zeolite having d6r as CBU include zeolites having AEI, AFT, AFV, AFX, AVL, CHA, EAB, EMT, ERI, FAU, GME, JSR, KFI, LEV, LTL, LTN, MOZ, MSO, MWW, OFF, SAS, SAT, SAV, SBS, SBT, SFW, SSF, SZR, TSC, or -WEN type structure.

Among these, a zeolite having a structure of an 8-membered oxygen ring or less is particularly preferable from the viewpoint of easily controlling the particle size. Examples of the zeolite having a structure of an 8-membered oxygen ring or less include zeolites having AEI, AFT, AFX, CHA, ERI, KFI, SAT, SAV, SFW, or TSC type structure. Among these, zeolites having AEI, AFX, CHA, or ERI type structure are particularly preferable, and a zeolite having a CHA type structure is most preferable, because the structure is stable even when the shape is controlled. In the description herein, the structure having an 8-membered oxygen ring means a structure in which the number of oxygen elements is 8 in the case where the number of oxygen is the largest in the pores composed of oxygen forming the zeolite framework and the T element (element other than oxygen constituting the framework).

### (Average Thermal Expansion Coefficient of Zeolite)

The average thermal expansion coefficient of the zeolite according to the first embodiment of the present invention is preferably low because it is easy to reduce the average thermal expansion coefficient of a liquid composition and a resin composite material, which will be described later, with a small amount. In addition, when the amount of the zeolite is small, various physical properties of the resin are not easily changed by the addition of the zeolite, which is also preferable. In particular, from the viewpoint of being able to suppress an increase in the viscosity of the liquid composition which will be described later, the average thermal expansion coefficient of the zeolite is preferably low. To be specific, the average thermal expansion coefficient of the zeolite is usually less than 0 ppm/K, preferably -2 ppm/K or less, more preferably -3 ppm/K or less, still more preferably -5 ppm/K or less, particularly preferably -6 ppm/K or less, and most preferably -8 ppm/K or less.

On the other hand, in consideration of using as a liquid composition and a resin composite material containing a zeolite and a resin, which will be described later, the average thermal expansion coefficient of the zeolite is preferably high from the viewpoint that the difference between the average thermal expansion coefficient of the zeolite and the average thermal expansion coefficient of the resin is small and the zeolite and the resin are hardly peeled off. Therefore, the average thermal expansion coefficient of the zeolite is usually -1000 ppm/K or more, preferably -900 ppm/K or more, more preferably -800 ppm/K or more, still more preferably -700 ppm/K or more, particularly preferably -500 ppm/K or more, and even more preferably -300 ppm/K or more. In particular, when it is used in an application in contact with other materials such as a sealing material and a substrate, the thermal expansion coefficient is preferably high, and specifically, it is preferably -100 ppm/K or more, more preferably -50 ppm/K or more, still more preferably -40 ppm/K or more, particularly preferably -30 ppm/K or more, even more preferably -25 ppm/K or more, and most preferably -20 ppm/K or more.

The average thermal expansion coefficient of the zeolite can be measured by calculating lattice constants using an X-ray diffractometer "D8 ADVANCE" manufactured by BRUKER Corporation and X-ray diffraction analysis software "JADE". Here, in order to eliminate the influence of moisture desorption, the measurement is usually performed in a state where the zeolite is dried.

The measurement of the average thermal expansion coefficient of the zeolite is usually performed in the range of 50 to 100°C. That is, the average thermal expansion coefficient is a numerical value representing a displacement of the lattice constants per 1°C from the average lattice constants at 50°C and the average lattice constants at 100°C when the zeolite is heated. Here, the average lattice constants at the respective temperatures are average values of the lattice constants of the a-axis, the b-axis, and the c-axis. The measurement of the average thermal expansion coefficient is performed by gradually raising the temperature after waiting until the lattice constants are stabilized.

In general, a resin often has a large thermal expansion coefficient in a high temperature region. Therefore, it is preferable that the average thermal expansion coefficient of the zeolite is low particularly when the temperature is increased to a high temperature region. To be specific, the average thermal expansion coefficient in the range of 50 to 350°C (high temperature region) is preferably -9.5 ppm/K or less, more preferably -10.0 ppm/K or less, and still more preferably -12.5 ppm/K or less. Here, the average thermal expansion coefficient (high temperature region) of the zeolite is a numerical value representing a displacement of the lattice constants per 1°C from the average lattice constants at 50°C and the average lattice constants at 350°C when the zeolite is heated.

### (Shape of Zeolite)

The shape of the zeolite according to the first embodiment of the present invention is preferably a spherical shape because it is easy to contain the zeolite while suppressing an increase in viscosity of a composition containing the zeolite. Specifically, it is preferable to have the following sphericity and roundness.

### <<Sphericity>>

The sphericity of the zeolite is preferably 0.6 or more, more preferably 0.65 or more, particularly preferably 0.7 or more, and most preferably 0.8 or more. The upper limit of the sphericity is not particularly limited, and the sphericity may be 1 or less. In addition, the sphericity in the case of a cubic shape, which is common in a zeolite, is 0.58. In the present application, the "sphericity" is an average value of 10 particles obtained by a scanning electron microscope (SEM).

In the description herein, "sphericity" is defined as "the ratio of the minimum diameter to the maximum diameter of a particle". Each of the maximum diameter and the minimum diameter can be determined by observation with a scanning electron microscope (SEM).

### <<Roundness>>

The roundness of the zeolite according to the first embodiment of the present invention is preferably 0.786 or more, more preferably 0.790 or more, still more preferably 0.795 or more, even more preferably 0.800 or more, yet still more preferably 0.805 or more, particularly preferably 0.810 or more, yet even more preferably 0.815 or more, and most preferably 0.820 or more. The upper limit of the roundness is not particularly limited, and the roundness may be 1 or less. In addition, the roundness in the case of a cubic shape, which is common in a zeolite, is 0.785.

In the description herein, "roundness" is defined as "4 × π × area/(circumference)²". The area and the circumference can be obtained by observation with a scanning electron microscope (SEM). In the present application, the "roundness" is an average value of 10 particles obtained by a scanning electron microscope (SEM).

### (Framework Density of Zeolite)

The framework density of the zeolite according to the first embodiment of the present invention is not particularly limited as long as the effects of the present invention are not impaired. The framework density of the zeolite is preferably low from the viewpoint that structural vibration of the zeolite is likely to occur and the average thermal expansion coefficient is likely to be low. Therefore, the framework density of the zeolite is preferably 17.0 T/1000 Å³ or less, and more preferably 16.0 T/1000 Å³ or less.

On the other hand, the framework density of the zeolite is preferably high from the viewpoint that the structural stability of the zeolite is likely to be high. Therefore, the framework density of the zeolite is preferably 12.0 T/1000 Å³ or more, more preferably 13.0 T/1000 Å³ or more, and still more preferably 14.0 T/1000 Å³ or more. When the framework density is within the above range, the zeolite can be used as a stable filler.

The framework density indicates the number of T atoms present per unit volume of the zeolite, and is a value determined by the structure of the zeolite. In the description herein, numerical values described in IZA Zeolite Structure Database, 2017 edition (http://www.iza-structure.org/databases/) may be used.

Examples of the zeolite having a framework density of more than 16.0 T/1000 Å³ and 17.0 T/1000 Å³ or less include zeolites having ERI, LTL, LTN, MOZ, OFF, SAT, SSF, or -WEN type structure.

Examples of the zeolite having a framework density of more than 15.0 T/1000 Å³ and 16.0 T/1000 Å³ or less include zeolites having AEI, AFT, AFV, AFX, AVL, EAB, GME, LEV, MWW, or SFW type structure.

Examples of the zeolite having a framework density of more than 14.0 T/1000 Å³ and 15.0 T/1000 Å³ or less include zeolites having CHA, KFI, SAS, or SAV type structure.

Examples of the zeolite in which the framework density is in the range of 14.0 T/1000 Å³ or less include zeolites having EMT, FAU, JSR, SBS, SBT, or TSC type structure.

### (Silica/Alumina Molar Ratio (SAR) of Zeolite)

The silica/alumina molar ratio (which may be referred to as "SAR", "Si/Al₂ molar ratio", or "Si/Al₂ ratio") of the zeolite according to the first embodiment of the present invention is not particularly limited as long as the effects of the present invention are not impaired. The SAR (Si/Al₂ ratio) of the zeolite is preferably high from the viewpoint that the moisture resistance of the resin composite material described later becomes high and the amount of the counter cation is easily controlled. Therefore, the SAR (Si/Al₂ ratio) of the zeolite is usually 2 or more, preferably 3 or more, more preferably 3.5 or more, still more preferably 4 or more, particularly preferably 4.5 or more, and most preferably 5 or more.

On the other hand, the SAR (Si/Al₂ ratio) of the zeolite is preferably low from the viewpoint of being easily produced at low cost. Therefore, the SAR (Si/Al₂ ratio) of the zeolite is usually 2000 or less, preferably 1000 or less, more preferably 500 or less, and still more preferably 100 or less. When the Si/Al₂ ratio is within the above range, the amount of the counter cation can be easily controlled, and the production cost of the zeolite can be reduced.

### (Counter Cation of Zeolite)

The counter cation of the zeolite according to the first embodiment of the present invention is not particularly limited as long as the effects of the present invention are not impaired. The counter cation of the zeolite is usually a proton, an alkali metal ion, or an alkaline earth metal ion. The counter cation is preferably a proton or an alkali metal ion, and more preferably a proton, a Li ion, a Na ion, or a K ion. In the case of an alkali metal ion or an alkaline earth metal ion, as the size thereof is smaller, the zeolite more easily exhibits an average thermal expansion coefficient of less than 0 ppm/K, which is preferable. Among these, the case where the counter cation of the zeolite is a proton is preferable because the average thermal expansion coefficient of the resin composite material is easily reduced. That is, as the zeolite, a proton type or an alkali metal type is preferable, and a proton type, a Li type, a Na type, or a K type is more preferable.

### (Crystallinity of Zeolite)

The crystallinity of the zeolite according to the first embodiment of the present invention is not particularly limited as long as the effects of the present invention are not impaired. The reason for this is that the Composite Building Unit (CBU) is presumed to be a factor having a greater influence on the average thermal expansion coefficient of the epoxy resin composite material than the structure defined by the code of the IZA. The crystallinity of the zeolite can be obtained by comparing with an X-ray diffraction peak of the zeolite to use a certain X-ray diffraction peak obtained by an X-ray diffractometer (for example, a table-top X-ray diffractometer D2 PHASER manufactured by BRUKER Corporation) as a reference. As a specific calculation example, the crystallinity of the LTA type zeolite of Scientific Reports 2016, 6, Article number: 29210 may be mentioned.

### (Surface Treatment of Zeolite)

The zeolite may be subjected to a surface treatment such as a silylation treatment or a fluorination treatment within a range in which the effects of the present invention are not impaired. The surface treatment may be a physical treatment or a chemical treatment.

### <Method for Producing Zeolite>

As the method for producing a zeolite, a known method can be applied. For example, in the case of producing a CHA-type zeolite, it can be produced with reference to the method described in JP 2009-097856 A.

On the other hand, in the case of producing the zeolite according to the first embodiment of the present invention (spherical zeolite having a small particle size), it is preferable to use a silane coupling agent in the hydrothermal synthesis. The silane coupling agent will be described in detail later.

In addition, the above-described particularly preferable zeolite can be produced by the following method (hereinafter, sometimes referred to as "method for producing a zeolite of the present invention").

The method for producing a zeolite of the present invention includes a step of hydrothermally synthesizing a raw material composition containing a silicon atom raw material, a water-soluble aluminum atom raw material, an organic structure directing agent, a silane coupling agent, and water. In addition, it is preferable that the method for producing a zeolite of the present invention further includes a firing step.

If necessary, a desired zeolite (hereinafter, sometimes referred to as "seed crystal zeolite") may be used.

### <<Silicon Atom Raw Material>>

The silicon atom raw material used in the present invention is not particularly limited, and various known substances can be used. For example, colloidal silica, amorphous silica, sodium silicate, trimethylethoxysilane, tetraethyl orthosilicate, aluminosilicate gel, and zeolite can be used. These may be used alone, or two or more thereof may be used in any combination at any ratio.

### <<Aluminum Atom Raw Material>>

As the aluminum atom raw material, a water-soluble raw material is preferably used. In addition, aluminum hydroxide is preferable from the viewpoint that the content of an alkali metal is small.

### <<Organic Structure Directing Agent>>

As the organic structure directing agent, various known substances such as tetraethylammonium hydroxide (TEAOH) and tetrapropylammonium hydroxide (TPAOH) can be used. Of these, N,N,N-trimethyl-1-adamantylammonium hydroxide (TMAdaOH) is preferred.

The amount of the organic structure directing agent used is usually 0.01 or more, preferably 0.02 or more, more preferably 0.03 or more, particularly preferably 0.04 or more, and most preferably 0.05 or more in terms of a molar ratio to silicon (Si) contained in the raw material composition. On the other hand, it is usually 1 or less, preferably 0.6 or less, more preferably 0.55 or less, and still more preferably 0.5 or less. When used within this range, it is considered that a high-purity spherical zeolite having few by-products is easily grown.

### <<Water>>

The amount of water used is usually 5 or more, preferably 7 or more, more preferably 9 or more, and still more preferably 10 or more in terms of a molar ratio to silicon (Si) contained in the raw material composition other than the seed crystal zeolite when the seed crystal zeolite described later is used, from the viewpoint that crystals are easily formed. When the amount of water is in this range, crystals are easily formed, which is preferable. In addition, it is considered that a zeolite having a large particle size is easily produced by hydrothermally synthesizing a zeolite under a condition in which the concentration of the raw material is diluted by increasing the amount of water. From the viewpoint of easily obtaining a cost reduction effect relating to the waste liquid treatment, the amount of water used is usually 50 or less, preferably 40 or less, more preferably 30 or less, and still more preferably 25 or less in terms of a molar ratio to silicon (Si).

### <<Silane Coupling Agent>>

In the method for producing a zeolite of the present invention, a zeolite having a high sphericity and a small particle size is easily obtained by using a silane coupling agent during the hydrothermal synthesis. As the silane coupling agent, various known silane coupling agents having an acrylic group or an amine structure can be used. Among these, a silane coupling agent having an epoxy group is preferable. Examples of the silane coupling agent having an epoxy group include 3-glycidoxypropyltrimethoxysilane.

In the case of using a silane coupling agent, the amount of the silane coupling agent to be used is usually 0.01 or more, preferably 0.015 or more, and more preferably 0.02 or more in terms of a molar ratio to silicon (Si) from the viewpoint of easily obtaining a shape controlling effect. On the other hand, it is usually 1 or less, preferably 0.5 or less, and more preferably 0.1 or less from the viewpoint of hardly causing inhibition of crystal growth due to excessive addition.

### <<Alkali Metal Atom Raw Material>>

For the production of a zeolite, an alkali metal atom raw material may be used. In the case of using an alkali metal atom raw material, the alkali metal atom is not particularly limited, a known alkali metal atom used in the synthesis of a zeolite can be used, and at least one kind of alkali metal selected from the group consisting of lithium, sodium, potassium, rubidium, and cesium is preferable. In addition, a plurality of kinds of alkali metal atoms may be used.

### <<Seed Crystal Zeolite>>

In the method for producing a zeolite, a zeolite to be a seed crystal may be used. In the case of using a seed crystal zeolite, one type may be used alone, or two or more types may be used in any combination at any ratio.

### <<Mixing of Raw Materials (Preparation of Pre-Reaction Raw Material Composition)>>

The raw material composition can be usually obtained by mixing the silicon atom raw material, the aluminum atom raw material, the organic structure directing agent, and water, and then adding the seed crystal zeolite in the case of using the seed crystal zeolite. In the method for producing a zeolite of the present invention, a silane coupling agent is preferably mixed with these raw materials.

In the production of the zeolite, in addition to the above-described components, components such as an acid component for accelerating the reaction and a metal stabilizer such as polyamine may be added in an arbitrary step as necessary.

### <<Aging>>

The raw material composition prepared as described above may be subjected to hydrothermal synthesis immediately after the preparation, but in order to obtain a zeolite having higher crystallinity, it is preferable to perform aging for a certain period of time under a predetermined temperature condition. In particular, when the reaction is scaled up, the raw materials are preferably aged while being stirred for a certain period of time because the stirring property is improved and the raw materials can be easily brought into a more uniform state. The aging temperature is usually 100°C or lower, preferably 95°C or lower, and more preferably 90°C or lower, and is usually 0°C or higher, and preferably 10°C or higher, although the lower limit is not particularly limited. The aging temperature may be constant during the aging, or may be changed stepwise or continuously. The aging time is not particularly limited, and is usually 2 hours or more, preferably 3 hours or more, and more preferably 5 hours or more, and on the other hand, it is usually 30 days or less, preferably 10 days or less, and more preferably 4 days or less.

### <<Hydrothermal Synthesis>>

Next, the obtained raw material composition is subjected to hydrothermal synthesis.

The hydrothermal synthesis is usually carried out by placing the raw material composition prepared as described above or an aqueous gel obtained by aging the same in a pressure-resistant container, and holding the mixture at a predetermined temperature under self-generated pressure or under gas pressure that does not inhibit crystallinity, under stirring or while rotating or shaking the container, or in a stationary state.

In order to increase the reaction speed, the reaction temperature in the hydrothermal synthesis is usually 120°C or higher, preferably 130°C or higher, more preferably 140°C or higher, and particularly preferably 150°C or higher. On the other hand, it is usually 230°C or lower, preferably 220°C or lower, more preferably 200°C or lower, and still more preferably 190°C or lower. The reaction time is not particularly limited, but is usually 2 hours or more, preferably 3 hours or more, and more preferably 5 hours or more, and on the other hand, it is usually 30 days or less, preferably 10 days or less, more preferably 7 days or less, and still more preferably 5 days or less. The reaction temperature may be constant during the reaction, or may be changed stepwise or continuously.

The reason why a particularly preferable zeolite can be produced by the method for producing a zeolite according to the present invention is considered to be that the zeolite grows while forming a state close to a spherical micelle structure by adsorption of the silane coupling agent on the surface of the growing zeolite crystal.

### [Second Embodiment]

### <Composition>

The composition according to the second embodiment of the present invention is a composition containing the zeolite according to the first embodiment and a resin. As will be described later, the average thermal expansion coefficient of the zeolite according to the first embodiment is likely to be extremely low. Therefore, by containing the zeolite, the thermal expansion of the composite material formed of the composition according to the second embodiment can be suppressed.

The content of the zeolite according to the first embodiment contained in the resin composition is preferably 25% by mass or more, more preferably 30% by mass or more, still more preferably 35% by mass or more, even more preferably 40% by mass or more, particularly preferably 45% by mass or more, and yet still more preferably 50% by mass or more, with respect to the total amount of the composition, from the viewpoint of reducing the thermal expansion coefficient while suppressing an increase in viscosity. On the other hand, the content is preferably 90% by mass or less, more preferably 80% by mass or less, still more preferably 75% by mass or less, and particularly preferably 70% by mass or less.

Furthermore, when the resin composition contains a filler other than the zeolite according to the first embodiment, the content of the zeolite of the present invention in the entire filler is preferably 10% by mass or more, more preferably 30% by mass or more, still more preferably 50% by mass or more, particularly preferably 70% by mass or more, and most preferably 90% by mass or more, because the increase in the viscosity of the kneaded resin is small and the thermal expansion coefficient of the cured product is easily reduced.

### (Resin)

The resin used in the composition according to the second embodiment of the present invention is not particularly limited as long as the effects of the present invention are exhibited, but is preferably at least one selected from the group consisting of an epoxy resin and a polyimide resin from the viewpoint of further exhibiting the effects as a composite material. In particular, when the composition according to the second embodiment of the present invention is used as a liquid composition useful as a sealing agent, an epoxy resin is preferable. In addition, when the composition is used as a composition useful as a substrate, a polyimide resin is preferable.

The amount of the resin contained in the composition of the present invention is preferably 5% by mass or more, and more preferably 10% by mass or more, with respect to the total amount of the composition, from the viewpoint of achieving both maintenance of excellent physical properties of the resin and heat resistance (resistance to thermal expansion) as a cured resin composition. On the other hand, the amount of the resin is preferably 50% by mass or less, more preferably 25% by mass or less, and particularly preferably 15% by mass or less.

### <<Epoxy Resin>>

The epoxy resin used in the present invention will be described in detail in a fourth embodiment of the present invention described later.

### <<Polyimide Resin>>

The polyimide resin used in the present invention is preferably a polyimide obtained from a tetracarboxylic acid dianhydride and a diamine, particularly an aromatic polyimide obtained from an aromatic tetracarboxylic acid dianhydride and an aromatic diamine, because the thermal expansion coefficient of the resin composite material tends to be low, and characteristics such as heat resistance, mechanical strength, electrical characteristics, and solvent resistance are excellent.

More specifically, it is preferable to use a polyimide powder obtained by spraying and granulating a polyimide precursor solution on a polyimide resin powder obtained by polymerizing and imidizing an aromatic tetracarboxylic acid component and p-phenylenediamine, and to composite the polyimide powder with a filler to obtain a resin composite material.

It is to be noted that the polyimide powder is granulated by the polyimide precursor causing particles of the polyimide powder to bond to each other, and the polyimide precursor serves as a binder in the aggregate. As the polyimide precursor, for example, a polyamic acid is used, and as a polyimide precursor solution used as a raw material, a polyamic acid produced by reacting a tetracarboxylic acid dianhydride with a diamine in the presence of a basic compound having a pKa of 7.5 or more using water and/or an alcohol-based solvent as a reaction solvent is used.

Examples of suitable aspects in the second embodiment include a composition containing the zeolite according to the first embodiment in which an epoxy resin is used as a resin, the viscosity at 23°C is 0.1 Pa·s or more and 250 Pa·s or less, and the content of the zeolite is 40 to 70% by mass. Here, the viscosity at 23°C is preferably 1 Pa·s or more and 30 Pa·s or less.

The liquid resin composition is useful as an underfill material (hereinafter, referred to as a "liquid sealing agent" in some cases), can reduce the average thermal expansion coefficient after curing, and is suitable as a sealing agent.

In addition, examples of another suitable aspect in the second embodiment include a resin composite material containing the zeolite according to the first embodiment in which an epoxy resin is used as a resin, the content of the zeolite is 40 to 70% by mass, and the average thermal expansion coefficient at 25 to 100°C is 10 to 30 ppm/K.

Since the composite material has a low average thermal expansion coefficient at a temperature of the glass transition temperature or lower, the composite material is useful as various materials, and is particularly effective for electronic devices.

### [Third Embodiment]

### <Composition>

The composition according to the third embodiment of the present invention is a composition containing the zeolite (small particle size zeolite) according to the first embodiment described above, a resin, and an inorganic filler having a particle size of 1.0 µm or more and 50 µm or less (hereinafter, also referred to as a large particle size inorganic filler).

### (Inorganic Filler)

In the case of a liquid composition, the particle size of the inorganic filler is preferably small from the viewpoint of easy filling of the liquid composition even in a narrow space. On the other hand, the particle size of the inorganic filler is preferably large from the viewpoint of difficulty in increasing the viscosity of the liquid composition. In the case where a filler having a small specific surface area and a filler having a large specific surface area are used in combination, the interaction between the filler and the resin increases as the specific surface area increases, and thus the viscosity of the liquid composition is likely to increase. For this reason, in order to reduce the viscosity of the liquid composition, the specific surface area of the filler is preferably small. The specific surface area tends to be larger as the particle size is smaller. In addition, the specific surface area also varies depending on the shape of the filler, and a spherical filler has the smallest specific surface area. Therefore, from the viewpoint of reducing the viscosity, it is preferable that the inorganic filler has a shape close to a spherical shape and has a large particle size.

The composition according to the third embodiment of the present invention uses a small particle size zeolite, but from the viewpoint of viscosity reduction, the outer surface area per volume is preferably 120 × 10⁻⁶ (/m) or less, and more preferably 80 × 10⁻⁶ (/m) or less.

In the composition according to the third embodiment of the present invention, by using a filler having a small particle size and a filler having a large particle size in combination, the small particles enter the gaps between the large particles, the filling amount can be increased, the thermal expansion coefficient can be reduced, and an increase in viscosity can be reduced. Therefore, the composition of the present invention preferably contains a small particle size zeolite and a large particle size inorganic filler from the viewpoint that the thermal expansion coefficient is likely to be low.

The particle size of the inorganic filler is measured in the same manner as that of the zeolite according to the first embodiment described above. That is, the particle size of the inorganic filler means a diameter (circle equivalent diameter) of a circle having an area equal to a projected area of the particle and having a maximum diameter in observation of the particle with a scanning electron microscope (SEM). In addition, the particle size is the particle size of the primary particle.

Examples of the inorganic filler used in the composition of the present invention include a zeolite and inorganic fillers other than a zeolite.

A zeolite is an inorganic filler having a low thermal expansion coefficient, and can reduce the thermal expansion coefficient of the epoxy resin composite material which is a cured product of the liquid composition according to one preferred aspect of the present invention. However, a zeolite has a porous structure and thus has a large specific surface area, and when a large amount of zeolite is blended, the viscosity of the liquid composition is likely to increase. In the present invention, as a result of various studies, it has been found that, for example, while the thermal expansion coefficient of the liquid epoxy resin composite material is reduced, an increase in the viscosity is prevented, and a lowering in the viscosity of the liquid composition can be realized by containing a large particle size inorganic filler to the liquid composition in addition to the small particle size zeolite such as the zeolite according to the first embodiment described above.

Examples of the inorganic filler other than the zeolite include at least one selected from the group consisting of metal, carbon, metal carbide, metal oxide, and metal nitride. Examples of the metal include silver, copper, aluminum, gold, nickel, iron, and titanium. Examples of the carbon include carbon black, carbon fiber, graphite, fullerene, and diamond. Examples of the metal carbide include silicon carbide, titanium carbide, and tungsten carbide. Examples of the metal oxide include magnesium oxide, aluminum oxide (alumina) silicon oxide such as silica, calcium oxide, zinc oxide, yttrium oxide, zirconium oxide, cerium oxide, ytterbium oxide, and sialon (a ceramic composed of silicon, aluminum, oxygen, and nitrogen). Examples of the metal nitride include boron nitride, aluminum nitride, and silicon nitride.

### (Large Particle Size Inorganic Filler)

The large particle size inorganic filler may be a zeolite or may be an inorganic filler other than a zeolite. Specific examples of the inorganic filler other than the zeolite are as described above.

The large particle size inorganic filler is preferably zeolite, metal nitride, or metal oxide from the viewpoint of lowering the thermal expansion coefficient.

### (Content of Large Particle Size Inorganic Filler)

In the composition according to the third embodiment of the present invention, the content of the large particle size inorganic filler in the composition is preferably large from the viewpoint that the effect of using the filler is easily sufficiently exhibited. On the other hand, when the resin composition is a liquid composition, the content is preferably small from the viewpoint that the fluidity of the liquid composition is increased and the resin composition is easily filled in a narrow space. In particular, since the specific surface area of the large particle size inorganic filler is small and the viscosity thereof is not easily increased, the fluidity thereof is easily increased by increasing the amount of the large particle size inorganic filler used.

Specifically, the content of the large particle size inorganic filler is preferably 20% by mass or more, more preferably 25% by mass or more, still more preferably 30% by mass or more, particularly preferably 40% by mass or more, and most preferably 45% by mass or more, with respect to the total amount of the liquid composition, from the viewpoint of reducing the thermal expansion coefficient while suppressing an increase in viscosity. On the other hand, the content is preferably 90% by mass or less, more preferably 80% by mass or less, still more preferably 75% by mass or less, and particularly preferably 70% by mass or less.

### (Shape of Large Particle Size Inorganic Filler)

The shape of the large particle size inorganic filler is not particularly limited as long as the composition and the resin composite material exhibit preferable performance, and may be a spherical shape, a whisker shape, a fibrous shape, a plate shape, or an aggregate thereof. However, a spherical shape is preferable because it is easy to contain the inorganic filler while suppressing an increase in viscosity.

The sphericity of the large particle size inorganic filler is preferably 0.6 or more, more preferably 0.65 or more, and particularly preferably 0.70 or more. The upper limit of the sphericity is not particularly limited, and the sphericity may be 1 or less.

Therefore, in the third embodiment of the present invention, the sphericity of each of the small particle size zeolite according to the first embodiment of the present invention and the large particle size inorganic filler is preferably 0.6 or more, more preferably 0.65 or more, and particularly preferably 0.70 or more. In addition, it is preferable that the sphericity of the large particle size inorganic filler is higher than that of the small particle size zeolite.

Further, the roundness of the large particle size inorganic filler is preferably 0.786 or more, more preferably 0.790 or more, still more preferably 0.795 or more, even more preferably 0.800 or more, yet still more preferably 0.805 or more, particularly preferably 0.810 or more, yet even more preferably 0.815 or more, and most preferably 0.820 or more. The upper limit of the roundness is not particularly limited, and the roundness may be 1 or less. The methods for measuring the sphericity and the roundness are as described above.

### (Small Particle Size Zeolite)

In the composition according to the third embodiment of the present invention, when the resin composition is a liquid composition, the content of the zeolite (small particle size zeolite) of the first embodiment in the composition is specifically preferably 1% by mass or more, more preferably 5% by mass or more, and particularly preferably 10% by mass or more, with respect to the total amount of the composition. On the other hand, the content is preferably 50% by mass or less, more preferably 45% by mass or less, and still more preferably 40% by mass or less.

In addition, the content of the zeolite (small particle size zeolite) in the total filler is preferably 10% by mass or more, more preferably 30% by mass or more, still more preferably 50% by mass or more, particularly preferably 70% by mass or more, and most preferably 90% by mass or more, because the thermal expansion coefficient of the cured product is easily reduced.

In the case where the large particle size inorganic filler is a zeolite, the content of the small particle size zeolite in the total filler is preferably high, more preferably 30% by mass or more, still more preferably 50% by mass or more, particularly preferably 70% by mass or more, and most preferably 90% by mass or more, from the viewpoint of easily filling a narrow space.

### (Amount of Total Inorganic Filler)

The total content of all the inorganic fillers (total inorganic filler) contained in the composition is preferably large from the viewpoint of easily exhibiting the effect as a filling material. On the other hand, the total content of all the inorganic fillers is preferably small from the viewpoint of high fluidity in the case of a liquid composition and easy filling even in a narrow space. Specifically, in the composition according to the third embodiment of the present invention, the total content of the total inorganic filler is preferably 30% by mass or more, more preferably 35% by mass or more, and particularly preferably 40% by mass or more, with respect to the total amount of the composition. On the other hand, it is preferably 95% by mass or less, more preferably 90% by mass or less, and particularly preferably 85% by mass or less.

The liquid composition according to the second and third embodiments of the present invention may contain a dispersant in order to enhance the dispersibility of the inorganic filler. The dispersant contained in the liquid composition containing a resin and a filler is mainly added to a liquid composition containing a resin and a filler having a large difference in polarity, thereby improving the interface state between them, and improving the compatibility, whereby effects of reducing the viscosity, improving the dispersibility of the filler, preventing the aggregation of the filler, and preventing the sedimentation of the filler can be exhibited.

The content of the dispersant is preferably large from the viewpoint of, for example, easily uniformly dispersing the inorganic filler in a case where the composition is in a liquid state. On the other hand, the content of the dispersant is preferably small from the viewpoint that an increase in the thermal expansion coefficient due to phase separation between the inorganic filler and a resin such as an epoxy resin is less likely to occur. Therefore, since the liquid composition easily fills a narrow space and has a low thermal expansion coefficient after curing, the content of the dispersant is preferably 0.1% by mass or more and 30% by mass or less and more preferably 0.1% by mass or more and 25% by mass or less with respect to the total amount of the composition.

In each of the above-described embodiments, when the composition is a liquid composition, the viscosity of the liquid composition is preferably low from the viewpoint of easily filling the composition even in a narrow space. On the other hand, the viscosity of the liquid composition is preferably high from the viewpoint that dripping hardly occurs at the time of filling the composition. The viscosity of the liquid composition at 23°C is preferably 0.1 Pa·s or more, more preferably 1 Pa·s or more, still more preferably 5 Pa·s or more, and particularly preferably 10 Pa·s or more. On the other hand, the viscosity of the liquid composition at 23°C is preferably 250 Pa·s or less, more preferably 200 Pa·s or less, still more preferably 150 Pa·s or less, particularly preferably 60 Pa·s or less, and even more preferably 30 Pa·s or less. Further, the viscosity at 23°C is most preferably 1 Pa·s or more and 30 Pa·s or less.

As a suitable embodiment of the above-described composition, a liquid composition using an epoxy resin as the resin and using the zeolite of the first embodiment as the zeolite is preferable. Here, the viscosity at 23°C is preferably 0.1 Pa·s or more and 250 Pa·s or less, and more preferably 1 Pa·s or more and 30 Pa·s or less. In addition, the content of the zeolite is preferably 40 to 70% by mass.

The liquid composition is useful as an underfill material, and is suitable as a sealing agent because the average thermal expansion coefficient after curing can be reduced.

When the composition in each of the second and third embodiments described above is in a liquid state, a resin composite material can be obtained by curing the composition. For example, when the resin is an epoxy resin, the resin composite material is an epoxy resin composite material. Details of the epoxy resin composite material are as described later. In addition, when the resin is a polyimide resin, the resin composite material is a polyimide resin composite material.

The average thermal expansion coefficient of the resin composite material at 25 to 100°C is preferably 0 ppm/K or more, more preferably 2 ppm/K or more, still more preferably 4 ppm/K or more, and particularly preferably 10 ppm/K or more. On the other hand, the average thermal expansion coefficient of the resin composite material at 25 to 100°C is preferably 200 ppm/K or less, more preferably 100 ppm/K or less, and particularly preferably 30 ppm/K or less.

In particular, in the composition of the second or third embodiment, when an epoxy resin is used as the resin and the zeolite of the first embodiment is used as the zeolite, the content of the zeolite is preferably 40 to 70% by mass, and the average thermal expansion coefficient at 25 to 100°C is preferably 10 to 30 ppm/K.

Such a resin composite material has a low average thermal expansion coefficient at a temperature of the glass transition temperature or lower, and thus is useful as a material for which various heat resistances are required, and is particularly effective for application to electronic devices.

### <Resin Composite Material>

In one aspect of the present invention, the resin composite material can be obtained by curing the above-described composition (the composition of the second or third embodiment). For example, in the case where the resin is an epoxy resin, an epoxy resin composite material can be obtained. In the case where the resin is an epoxy resin, the composition is preferably a liquid composition. The epoxy resin composition and the method for producing an epoxy resin composite material will be described in detail in a fourth embodiment of the invention described later.

In addition, in the case where the resin is a polyimide resin, a polyimide resin composite material can be obtained. As a method for producing a polyimide resin composite material, for example, the method described below may be performed.

### (Method for Producing Polyimide Resin Composite Material)

For molding the polyimide resin composite material, various known press apparatuses for molding a thermoplastic resin can be used. The temperature for heating at the time of molding is affected by the properties of the resins used and is not particularly limited, and is usually 250°C or higher, preferably 300°C or higher, more preferably 350°C or higher, and still more preferably 390°C or higher. In addition, from the viewpoint that deterioration of the resin during hot pressing hardly occurs, it is preferable to use a vacuum press apparatus capable of reducing the amount of oxygen in the press machine during heating or a press apparatus provided with a nitrogen substitution apparatus.

### [Fourth Embodiment]

### <Liquid Composition>

The liquid composition according to the fourth embodiment of the present invention contains an epoxy resin and an inorganic filler.

### (Inorganic Filler)

In the liquid composition according to the fourth embodiment, zeolite and an inorganic filler other than zeolite are used as the inorganic filler. As the inorganic filler other than zeolite, the same filler as the inorganic filler used in the third embodiment is preferable, and the preferable range is also the same as the above-described range.

The inorganic filler contained in the liquid composition according to the fourth embodiment of the present invention contains a zeolite having a particle size of 0.05 µm or more and 1 µm or less (small particle size zeolite) and an inorganic filler having a particle size of 1 µm or more and less than 50 µm (large particle size inorganic filler).

The zeolite is an inorganic filler having a low thermal expansion coefficient, and can reduce the thermal expansion coefficient of the epoxy resin composite material which is a cured product of the liquid composition, but has a large specific surface area, and when a large amount of zeolite is blended, the viscosity of the liquid composition is likely to increase. In the present invention, as a result of various studies, by including a large particle size inorganic filler in a liquid composition in addition to a small particle size zeolite, it is possible to prevent an increase in viscosity while lowering the thermal expansion coefficient of the epoxy resin composite material, and to realize a low viscosity of the liquid composition.

The particle size of the inorganic filler is preferably small from the viewpoint of easily filling the liquid composition even in a narrow space. On the other hand, the particle size of the inorganic filler is preferably large from the viewpoint of difficulty in increasing the viscosity of the liquid composition. In the case where a filler having a small specific surface area and a filler having a large specific surface area are used in combination, the interaction between the filler and the resin increases as the specific surface area increases, and thus the viscosity of the liquid composition is likely to increase. For this reason, in order to reduce the viscosity of the liquid composition, the specific surface area of the filler is preferably small. The specific surface area tends to be larger as the particle size is smaller. In addition, the specific surface area also varies depending on the shape of the filler, and a spherical filler has the smallest specific surface area. Therefore, from the viewpoint of reducing the viscosity, it is preferable that the inorganic filler has a shape close to a spherical shape and has a large particle size. Therefore, particularly for the small particle size zeolite, the specific surface area is preferably 120 × 10⁻⁶ (/m) or less, and more preferably 80 × 10⁻⁶ (/m) or less.

In the present invention, by using a filler having a small particle size and a filler having a large particle size in combination, the small particles enter the gaps between the large particles, the filling amount can be increased, the thermal expansion coefficient can be reduced, and an increase in viscosity can be reduced.

The particle size of the inorganic filler such as zeolite is the particle size of each particle, and means a diameter (circle equivalent diameter) of a circle having an area equal to a projected area of the particle and having a maximum diameter in observation of the particle with a scanning electron microscope (SEM). In addition, the particle size is the particle size of the primary particle.

### (Content of Small Particle Size Zeolite)

In the liquid composition according to the fourth embodiment of the present invention, the content of the small particle size zeolite is preferably large from the viewpoint that the effect of using the filler is easily sufficiently exhibited. On the other hand, the content of the small particle size zeolite is preferably small from the viewpoint that the fluidity of the liquid composition is increased and it is easy to fill a narrow space with the liquid composition. In particular, since the specific surface area of the small particle size zeolite is large and the viscosity thereof is easily increased, the fluidity thereof is easily increased by reducing the amount of the small particle size zeolite used.

In the liquid composition according to the fourth embodiment of the present invention, specifically, the content of the small particle size zeolite is preferably 1% by mass or more, more preferably 5% by mass or more, and particularly preferably 10% by mass or more with respect to the total amount of the liquid composition. On the other hand, the content is preferably 50% by mass or less, more preferably 45% by mass or less, and still more preferably 40% by mass or less.

### (Large Particle Size Inorganic Filler)

The large particle size inorganic filler may be a zeolite or may be an inorganic filler other than a zeolite. Specific examples of the inorganic filler other than the zeolite are as described above.

The large particle size inorganic filler is preferably zeolite, metal nitride, or metal oxide from the viewpoint of lowering the thermal expansion coefficient.

The content of the large particle size inorganic filler is preferably large from the viewpoint that the effect of reducing the average thermal expansion coefficient is easily exhibited. On the other hand, the content thereof is preferably small from the viewpoint that the fluidity of the liquid composition is increased and it is easy to fill a narrow space with the liquid composition. Specifically, the content of the large particle size inorganic filler is preferably 20% by mass or more, more preferably 25% by mass or more, and particularly preferably 30% by mass or more with respect to the total amount of the liquid composition. On the other hand, the content of the large particle size inorganic filler is preferably 80% by mass or less, more preferably 75% by mass or less, and particularly preferably 70% by mass or less.

In particular, since the specific surface area of the large particle size inorganic filler is small and the viscosity thereof is not easily increased, the fluidity thereof is easily increased by increasing the amount of the large particle size inorganic filler used.

### (Zeolite)

Hereinafter, the zeolite used in the present invention will be described in more detail. In the following description, the small particle size zeolite is described unless otherwise specified. However, even in a case where the zeolite is used as an inorganic filler other than the small particle size zeolite, it is preferable that the zeolite has the characteristics described below except for the particle size. For example, in a case where a zeolite is used as the large particle size inorganic filler, it is preferable that the zeolite used as the large particle size inorganic filler also has the characteristics described below. The same applies to the zeolite in fifth and sixth embodiments described below.

As the small particle size zeolite, the zeolite according to the first embodiment described above is preferable.

### (Structure of Zeolite)

A zeolite is a compound containing silicon or aluminum and oxygen and having a TO₄ unit (T element is an element other than oxygen constituting the framework) as a basic unit. Specific examples of the zeolite include a crystalline porous aluminosilicate, a crystalline porous aluminophosphate (ALPO), or a crystalline porous silicoaluminophosphate (SAPO). Among these, the zeolite according to the fourth embodiment is preferably an aluminosilicate.

A zeolite is composed of a structural unit called Composite Building Unit (hereinafter, may be referred to as "CBU") in which several (several to several tens) TO₄ units are connected. Therefore, it has regular channels (tubular pores) and cavities.

The CBU and the crystal structure of the zeolite to be described later can be represented by a code that defines the structure of the zeolite defined by the International Zeolite Association (IZA). The structure of the zeolite can be identified by using a Zeolite Structure Database, 2018 edition (http://www.iza-structure.org/databases/) on the basis of an X-ray diffraction pattern obtained by an X-ray structure analyzer (for example, a table-top X-ray diffractometer "D2 PHASER" manufactured by BRUKER Corporation).

### (Composition of Zeolite)

The zeolite of the present invention is not particularly limited as long as it is an aspect in which the effects of the present invention are not impaired, and is preferably an aluminosilicate including at least an aluminum atom and a silicon atom in a framework structure from the viewpoint of being advantageous for application to a filler use. One type of zeolite may be used alone, or two or more types of zeolites may be used in any combination and in any ratio.

### (Framework of Zeolite)

The framework of a zeolite is not particularly limited as long as the liquid composition and an epoxy resin composite obtained by curing the liquid composition, which will be described later, exhibit preferable performances. The framework of the zeolite preferably includes a structure of at least one of d6r and mtw as CBU, and more preferably has d6r, since an epoxy resin composite material having a low thermal expansion coefficient is easily obtained by curing the liquid composition. Specifically, the liquid composition and the epoxy resin composite material preferably contain 1% by mass or more of the zeolite having the above-described preferred structure as CBU and an epoxy resin.

Examples of the zeolite having d6r as CBU include zeolites having AEI, AFT, AFV, AFX, AVL, CHA, EAB, EMT, ERI, FAU, GME, JSR, KFI, LEV, LTL, LTN, MOZ, MSO, MWW, OFF, SAS, SAT, SAV, SBS, SBT, SFW, SSF, SZR, TSC, or -WEN type structure.

Examples of the zeolite having mtw as CBU include zeolites having *BEA, BEC, CSV, GON, ISV, ITG, *-ITN, IWS, MSE, MTW, SFH, SFN, SSF, *-SSO, UOS, or UOV type structure.

In order to have a three dimensional interaction with a part of the epoxy groups contained in the epoxy resin, it is more preferable that the zeolite further has a three dimensional channel. Examples thereof include zeolites having AEI, AFT, AFX, *BEA, BEC, CHA, EMT, ERI, FAU, GME, ISV, ITG, *-ITN, IWS, JSR, KFI, MOZ, MSE, OFF, SAT, SAV, SBS, SBT, SFW, SZR, TSC, UOS, UOV, or -WEN type structure.

Among these, a zeolite having a structure of an 8-membered oxygen ring or less is particularly preferable from the viewpoint of easily controlling the particle size. Examples of the zeolite having a structure of an 8-membered oxygen ring or less include zeolites having AEI, AFT, AFX, CHA, ERI, KFI, SAT, SAV, SFW, or TSC type structure. Among these, zeolites having AEI, AFX, CHA, or ERI type structure are more preferable, and zeolites having CHA type structure are most preferable, because the structure is stable even when the shape is controlled. In the description herein, the structure having an 8-membered oxygen ring means a structure in which the number of oxygen elements is 8 in the case where the number of oxygen is the largest in the pores composed of oxygen forming the zeolite framework and the T element (element other than oxygen constituting the framework).

### (Average Thermal Expansion Coefficient of Zeolite)

The average thermal expansion coefficient of the zeolite is not particularly limited as long as the liquid composition and the epoxy resin composite material obtained by curing the liquid composition exhibit preferable performances. The average thermal expansion coefficient of the zeolite is preferably low from the viewpoint that the average thermal expansion coefficients of the liquid composition and the epoxy resin composite material are easily decreased with a small amount of the zeolite, and is also preferably low from the viewpoint that an increase in the viscosity of the liquid composition due to the addition of the filler can be suppressed with a small amount of the zeolite. Therefore, the average thermal expansion coefficient of the zeolite is usually less than 0 ppm/K, preferably -2 ppm/K or less, more preferably -3 ppm/K or less, still more preferably -5 ppm/K or less, particularly preferably -6 ppm/K or less, and most preferably -8 ppm/K or less.

On the other hand, the average thermal expansion coefficient of the zeolite is preferably high from the viewpoint that the difference between the average thermal expansion coefficient of the zeolite and that of the resin is small and the zeolite and the resin are hardly peeled off. Therefore, the average thermal expansion coefficient of the zeolite is usually -1000 ppm/K or more, preferably -900 ppm/K or more, more preferably -800 ppm/K or more, still more preferably -700 ppm/K or more, particularly preferably -500 ppm/K or more, and most preferably -300 ppm/K or more.

That is, when the average thermal expansion coefficient of the zeolite is within the above-described range, it is possible to suppress an increase in viscosity of the liquid composition, to facilitate filling of the liquid composition into gaps between various constituent members, and to reduce the average thermal expansion coefficient of the epoxy resin composite material after curing. The average thermal expansion coefficient of the zeolite can be measured by calculating lattice constants using an X-ray diffractometer "D8 ADVANCE" manufactured by BRUKER Corporation and X-ray diffraction analysis software "JADE".

### (Shape of Zeolite)

The shape of the zeolite is not particularly limited as long as the liquid composition and the epoxy resin composite material exhibit preferable performances, and may be a spherical shape, a whisker shape, a fibrous shape, a plate shape, or aggregates thereof. However, a spherical shape is preferable because it is easy to contain the zeolite while suppressing an increase in viscosity.

The sphericity of the zeolite is preferably 0.6 or more, more preferably 0.65 or more, and particularly preferably 0.70 or more. The upper limit of the sphericity is not particularly limited, and may be 1 or less.

In the description herein, "sphericity" is defined as "the ratio of the minimum diameter to the maximum diameter of a particle". Fifty zeolite particles contained in the liquid composition or the epoxy resin composite material are selected at random, the sphericity thereof is measured, and the measured sphericity is defined as an average value thereof. Each of the maximum diameter and the minimum diameter can be determined by observation with a scanning electron microscope (SEM). In the first embodiment, as described above, the sphericity of the small particle size zeolite is preferably in the above-described range.

### (Framework Density of Zeolite)

The framework density of the zeolite is not particularly limited as long as the effects of the present invention are not impaired. The framework density of the zeolite is preferably low from the viewpoint that structural vibration of the zeolite is likely to occur and the average thermal expansion coefficient is likely to be low. Therefore, the framework density of the zeolite is preferably 17.0 T/1000 Å³ or less, and more preferably 16.0 T/1000 Å³ or less.

On the other hand, the framework density of the zeolite is preferably high from the viewpoint that the structural stability of the zeolite is likely to be high. Therefore, the framework density of the zeolite is preferably 12.0 T/1000 Å³ or more, more preferably 13.0 T/1000 Å³ or more, and still more preferably 14.0 T/1000 Å³ or more. When the framework density is within the above range, the zeolite can be used as a stable filler.

The framework density indicates the number of T atoms present per unit volume of the zeolite, and is a value determined by the structure of the zeolite. In the description herein, numerical values described in IZA Zeolite Structure Database, 2017 edition (http://www.iza-structure.org/databases/) may be used.

Examples of the zeolite having a framework density of more than 16.0 T/1000 Å³ and 17.0 T/1000 Å³ or less include zeolites having CSV, ERI, ITG, LTL, LTN, MOZ, MSE, OFF, SAT, SFH, SFN, SSF, *-SSO, or -WEN type structure.

Examples of the zeolite having a framework density of more than 15.0 T/1000 Å³ and 16.0 T/1000 Å³ or less include zeolites having AEI, AFT, AFV, AFX, AVL, *BEA, BEC, EAB, GME, *-ITN, LEV, MWW, or SFW type structure.

Examples of the zeolite having a framework density of more than 14.0 T/1000 Å³ and 15.0 T/1000 Å³ or less include zeolites having CHA, ISV, IWS, KFI, SAS, or SAV type structure.

Examples of the zeolite in which the framework density is in the range of 14.0 T/1000 Å³ or less include zeolites having EMT, FAU, JSR, SBS, SBT, or TSC type structure.

### (Silica/Alumina Molar Ratio (SAR) of Zeolite)

The silica/alumina molar ratio (which may be referred to as "SAR", "Si/Al₂ molar ratio", or "Si/Al₂ ratio") of the zeolite is not particularly limited as long as the effects of the present invention are not impaired. The SAR (Si/Al₂ ratio) of the zeolite is preferably high from the viewpoint that the moisture resistance of the epoxy resin composite material becomes high and the amount of the counter cation is easily controlled. Therefore, the SAR (Si/Al₂ ratio) of the zeolite is usually 2 or more, preferably 3 or more, more preferably 3.5 or more, still more preferably 4 or more, particularly preferably 4.5 or more, and most preferably 5 or more.

On the other hand, the SAR (Si/Al₂ ratio) of the zeolite is preferably low from the viewpoint of being easily produced at low cost. Therefore, the SAR (Si/Al₂ ratio) of the zeolite is usually 2000 or less, preferably 1000 or less, more preferably 500 or less, and still more preferably 100 or less. When the Si/Al₂ ratio is within the above range, the amount of the counter cation can be easily controlled, and the production cost of the zeolite can be reduced.

Note that in the case where an element such as gallium, iron, boron, titanium, zirconium, tin, zinc, or phosphorus is used instead of silicon or aluminum, the molar ratio of an oxide of the element used instead may be converted into the molar ratio of alumina or silica. Specifically, in the case where gallium is used instead of aluminum, the molar ratio of gallium oxide may be converted into the molar ratio of alumina.

The Si/Al₂ ratio of the zeolite can be adjusted by the type and ratio of the silicon-containing compound and the aluminum-containing compound as raw materials, the type and amount of the structure directing agent, the use of seed crystals, and synthesis conditions such as temperature and time.

### (Counter Cation of Zeolite)

The counter cation of the zeolite is not particularly limited as long as the effects of the present invention are not impaired. The counter cation of the zeolite is usually a structure directing agent, a proton, an alkali metal ion, or an alkaline earth metal ion, is preferably a structure directing agent, a proton, or an alkali metal ion, and is more preferably a structure directing agent, a proton, a Li ion, a Na ion, or a K ion. In the case where the counter cation of the zeolite is a structure directing agent, the zeolite is more flexible than alkali metal ions and alkaline earth metal ions, and thus the zeolite more easily exhibits an average thermal expansion coefficient of less than 0 ppm/K, which is preferable. In the case where the counter cation of the zeolite is an alkali metal ion or an alkaline earth metal ion, as the size thereof is smaller, the zeolite more easily exhibits an average thermal expansion coefficient of less than 0 ppm/K, which is preferable. Among these, the case where the counter cation of the zeolite is a proton is preferable because the average thermal expansion coefficient of the resin composite material is easily reduced. That is, the zeolite is preferably as-made (structure directing agent-containing type), proton type, alkali metal type, and more preferably as-made, proton type, Li type, Na type, and K type. The structure directing agent is a template used in the production of the zeolite.

### (Crystallinity of Zeolite)

The crystallinity of the zeolite is not particularly limited as long as the effects of the present invention are not impaired. The reason for this is that the Composite Building Unit (CBU) is presumed to be a factor having a greater influence on the average thermal expansion coefficient of the epoxy resin composite material than the structure defined by the code of the IZA. The crystallinity of the zeolite can be obtained by comparing with an X-ray diffraction peak of the zeolite to use a certain X-ray diffraction peak obtained by an X-ray diffractometer (for example, a table-top X-ray diffractometer D2 PHASER manufactured by BRUKER Corporation) as a reference. As a specific calculation example, the crystallinity of the LTA type zeolite of Scientific Reports 2016, 6, Article number: 29210 may be mentioned.

### (Surface Treatment of Zeolite)

The zeolite may be subjected to a surface treatment such as a silylation treatment or a fluorination treatment within a range in which the effects of the present invention are not impaired. The surface treatment may be a physical treatment or may be a chemical treatment.

### (Method for Producing Zeolite)

As the method for producing a zeolite, a known method can be applied. For example, in the case of producing a CHA-type zeolite, it can be produced with reference to the method described in JP 2009-097856 A. In the case of producing a zeolite having a large particle size, hydrothermal synthesis may be performed by appropriately controlling the type and ratio of raw materials, synthesis time, and temperature. Specifically, for example, according to the method described in Microporous and Mesoporous Materials 21 (1998) 24, a zeolite having a large particle size can be produced by increasing the amount of water at the time of synthesis and performing synthesis under a condition in which the concentration of raw materials is diluted.

### (Shape of Large Particle Size Inorganic Filler)

The shape of the large particle size inorganic filler is not particularly limited as long as the liquid composition and the resin composite material exhibit preferable performance, and may be a spherical shape, a whisker shape, a fibrous shape, a plate shape, or an aggregate thereof. However, a spherical shape is preferable because it is easy to contain the inorganic filler while suppressing an increase in viscosity.

The sphericity of the large particle size inorganic filler is preferably 0.6 or more, more preferably 0.65 or more, and particularly preferably 0.70 or more. The upper limit of the sphericity is not particularly limited, and the sphericity may be 1 or less.

Therefore, in the fourth embodiment of the present invention, the sphericity of each of the small particle size zeolite and the large particle size inorganic filler is preferably 0.6 or more, more preferably 0.65 or more, and particularly preferably 0.70 or more.

In addition, it is preferable that the sphericity of the large particle size inorganic filler is higher than that of the small particle size zeolite.

### (Amount of Total Inorganic Filler)

The total content of all the inorganic fillers (total inorganic filler) contained in the liquid composition is preferably large from the viewpoint of easily exhibiting the effect as a filling material. On the other hand, the content thereof is preferably small from the viewpoint that the fluidity of the liquid composition is high and it is easy to fill a narrow space with the liquid composition. Specifically, in the liquid composition according to the fourth embodiment of the present invention, the total content of the total inorganic filler is preferably 30% by mass or more, more preferably 35% by mass or more, and particularly preferably 40% by mass or more, with respect to the total amount of the composition. On the other hand, it is preferably 95% by mass or less, more preferably 90% by mass or less, and particularly preferably 85% by mass or less.

### (Epoxy Resin)

As the epoxy resin used in the present invention, an epoxy compound having an aromatic ring such as a bisphenol A type skeleton, a bisphenol F type skeleton, or a biphenyl skeleton is preferably used because the thermal expansion coefficient of the epoxy resin composite material obtained by curing the liquid composition is likely to be low. Specific examples of the epoxy resin include a bisphenol A type epoxy resin, a bisphenol F type epoxy resin, a bisphenol S type epoxy resin, a biphenyl type epoxy resin, a naphthalene ring-containing epoxy resin, an epoxy resin having a dicyclopentadiene skeleton, a phenol novolak type epoxy resin, a cresol novolak type epoxy resin, a triphenylmethane type epoxy resin, an aminophenol type epoxy resin, an aliphatic epoxy resin, and a copolymer epoxy resin of an aliphatic epoxy resin and an aromatic epoxy resin. Among these, a bisphenol A type epoxy resin, a bisphenol F type epoxy resin, a bisphenol S type epoxy resin, a biphenyl type epoxy resin, and a naphthalene ring-containing epoxy resin are preferable, and a bisphenol A type epoxy resin, a bisphenol F type epoxy resin, a naphthalene ring-containing epoxy resin, an aminophenol type epoxy resin, and a biphenyl type epoxy resin are more preferable.

It is preferable to use a polyfunctional epoxy resin from the viewpoint that the glass transition temperature of the epoxy resin composite material obtained by thermally curing the liquid composition tends to be high. As the polyfunctional epoxy resins, glycidyl ether-type polyfunctional epoxy resins such as epoxy resins produced from various phenols such as phenol novolak resins, cresol novolak resins, bisphenol A novolak resins, dicyclopentadiene phenol resins, phenol aralkyl resins, naphthol novolak resins, biphenyl novolak resins, terpene phenol resins, and heavy oil-modified phenol resins, and various phenol-based compounds such as polyhydric phenol resins obtained by a condensation reaction between various phenols and various aldehydes such as hydroxybenzaldehyde, crotonaldehyde, and glyoxal, and epihalohydrin are preferable.

From the viewpoint of fluidity, the epoxy resins used in the present invention preferably have a viscosity at 23°C of 5 Pa·s or less, and more preferably 0.1 to 3 Pa·s. The method for measuring the viscosity of epoxy resins is specified in JIS K 7233 (1986), and a single cylinder type rotational viscosimeter method is suitable. The viscosity at 23°C of the epoxy resins used in the present invention may be measured using a B-type rotational viscosimeter ("LVDV-1 Pri", manufactured by Brookfield Engineering Laboratories, Inc., spindle: S62), which is one of the single cylinder type rotational viscosimeter methods.

From the viewpoint of viscosity control, the epoxy equivalent of the epoxy resin is preferably 50 g/equivalent or more and 500 g/equivalent or less, and more preferably 90 g/equivalent or more and 150 g/equivalent or less. The epoxy equivalent is preferably high in terms of excellent heat resistance. On the other hand, the epoxy equivalent is preferably low from the viewpoint that the filling property of the liquid composition tends to be good and the bonding property by filling tends to be high due to low melting temperature and low viscosity of the epoxy resins.

One type of epoxy resin may be used alone, or two or more types of epoxy resins may be mixed and used in an arbitrary combination and ratio, and the epoxy equivalent in the case of mixing is the equivalent of the mixture.

The content of the epoxy resin in the liquid composition of the present invention is preferably small from the viewpoint that the content of the inorganic filler is relatively large and the thermal expansion coefficient is easily reduced. On the other hand, the content of the epoxy resin is preferably large from the viewpoint that the excellent physical properties of the epoxy resin are easily maintained. Specifically, the content of the epoxy resin is preferably 5% by mass or more, and more preferably 10% by mass or more with respect to the total amount of the composition. On the other hand, it is preferably 50% by mass or less, more preferably 25% by mass or less, and particularly preferably 15% by mass or less.

### (Curing Agent)

The liquid composition of the present invention preferably further contains a curing agent. The curing agent refers to a substance that contributes to crosslinking reaction between crosslinking groups of the epoxy resin.

The curing agent is not particularly limited, and a curing agent generally known as an epoxy resin curing agent can be used. Examples of the curing agent include phenol-based curing agents, amine-based curing agents such as aliphatic amines, polyether amines, alicyclic amines, and aromatic amines, acid anhydride-based curing agents, amide-based curing agents, tertiary amines, imidazole and derivatives thereof, organic phosphines, phosphonium salts, tetraphenylboron salts, organic acid dihydrazides, halogenated boron-amine complexes, polymercaptan-based curing agents, isocyanate-based curing agents, blocked isocyanate-based curing agents, and dicyandiamide compounds. From the viewpoint of imparting fluidity and rapid curability, the curing agent is preferably an acid anhydride-based curing agent.

Specific examples of the phenol-based curing agent include bisphenol A, bisphenol F, 4,4'-dihydroxydiphenylmethane, 4,4'-dihydroxydiphenyl ether, 1,4-bis(4-hydroxyphenoxy)benzene, 1,3-bis(4-hydroxyphenoxy)benzene, 4,4'-dihydroxydiphenyl sulfide, 4,4'-dihydroxydiphenyl ketone, 4,4'-dihydroxydiphenyl sulfone, 4,4'-dihydroxybiphenyl, 2,2'-dihydroxybiphenyl, 10-(2,5-dihydroxyphenyl)-10H-9-oxa-10-phosphaphenanthrene-10-oxide, phenol novolak, bisphenol-A novolak, o-cresol novolak, m-cresol novolak, p-cresol novolak, xylenol novolak, poly-p-hydroxystyrene, hydroquinone, resorcinol, catechol, t-butylcatechol, t-butylhydroquinone, fluoroglycinol, pyrogallol, t-butylpyrogallol, allylated pyrogallol, polyallylated pyrogallol, 1,2,4-benzenetriol, 2,3,4-trihydroxybenzophenone, 1,2-dihydroxynaphthalene, 1,3-dihydroxynaphthalene, 1,4-dihydroxynaphthalene, 1,5-dihydroxynaphthalene, 1,6-dihydroxynaphthalene, 1,7-dihydroxynaphthalene, 1,8-dihydroxynaphthalene, 2,3-dihydroxynaphthalene, 2,4-dihydroxynaphthalene, 2,5-dihydroxynaphthalene, 2,6-dihydroxynaphthalene, 2,7-dihydroxynaphthalene, 2,8-dihydroxynaphthalene, allylated products or polyallylated products of the above-mentioned dihydroxynaphthalene, allylated bisphenol A, allylated bisphenol F, allylated phenol novolak, and allylated pyrogallol.

Specific examples of the amine-based curing agent include aliphatic amines such as ethylenediamine, 1,3-diaminopropane, 1,4-diaminopropane, hexamethylenediamine, 2,5-dimethylhexamethylenediamine, trimethylhexamethylenediamine, diethylenetriamine, iminobispropylamine, bis(hexamethylene)triamine, triethylenetetramine, tetraethylenepentamine, pentaethylenehexamine, N-hydroxyethylethylenediamine, and tetra(hydroxyethyl)ethylenediamine.

Examples of the polyether amines include triethylene glycol diamine, tetraethylene glycol diamine, diethylene glycol bis(propylamine), polyoxypropylene diamine, and polyoxypropylene triamines.

Examples of the alicyclic amines include isophorone diamine, methacene diamine, N-aminoethylpiperazine, bis(4-amino-3-methyldicyclohexyl)methane, bis(aminomethyl)cyclohexane, 3,9-bis(3-aminopropyl)-2,4,8,10-tetraoxaspiro(5,5)undecane, and norbornene diamine.

Examples of the aromatic amines include tetrachloro-p-xylenediamine, m-xylenediamine, p-xylenediamine, m-phenylenediamine, o-phenylenediamine, p-phenylenediamine, 2,4-diaminoanisole, 2,4-toluenediamine, 2,4-diaminodiphenylmethane, 4,4'-diaminodiphenylmethane, 4,4'-diamino-1,2-diphenylethane, 2,4-diaminodiphenylsulfone, 4,4'-diaminodiphenylsulfone, m-aminophenol, m-aminobenzylamine, benzyldimethylamine, 2-dimethylaminomethylphenol, triethanolamine, methylbenzylamine, α-(m-aminophenyl)ethylamine, α-(p-aminophenyl)ethylamine, diaminodiethyldimethyldiphenylmethane, and α,α'-bis(4-aminophenyl)-p-diisopropylbenzene.

Specific examples of the acid anhydride-based curing agent include dodecenylsuccinic anhydride, polyadipic acid anhydride, polyazelaic acid anhydride, polysebacic acid anhydride, poly(ethyloctadecanedioic acid) anhydride, poly(phenylhexadecanedioic acid) anhydride, methyltetrahydrophthalic anhydride, methylhexahydrophthalic anhydride, hexahydrophthalic anhydride, methylhimic anhydride, tetrahydrophthalic anhydride, trialkyltetrahydrophthalic anhydride, methylcyclohexenedicarboxylic acid anhydride, methylcyclohexenetetracarboxylic acid anhydride, phthalic anhydride, trimellitic anhydride, pyromellitic anhydride, benzophenonetetracarboxylic acid anhydride, ethylene glycol bistrimellitate dianhydride, HET anhydride, nadic anhydride, methylnadic anhydride, 5-(2,5-dioxotetrahydro-3-furanyl)-3-methyl-3-cyclohexane-1,2-dicarboxylic acid anhydride, 3,4-dimethyl-6-(2-methyl-1-propenyl)-4-cyclohexene-1,2-dicarboxylic acid anhydride, 3,4-dicarboxy-1,2,3,4-tetrahydro-1-naphthalenesuccinic acid dianhydride, and 1-methyl-dicarboxy-1,2,3,4-tetrahydro-1-naphthalenesuccinic acid dianhydride.

Examples of the amide-based curing agent include dicyandiamide and polyamide resin.

Examples of the tertiary amine include 1,8-diazabicyclo(5,4,0)undecene-7, triethylenediamine, benzyldimethylamine, triethanolamine, dimethylaminoethanol, and tris(dimethylaminomethyl)phenol.

Examples of the imidazole and derivatives thereof include 1-cyanoethyl-2-phenylimidazole, 2-phenylimidazole, 2-ethyl-4(5)-methylimidazole, 2-phenyl-4-methylimidazole, 1-benzyl-2-methylimidazole, 1-benzyl-2-phenylimidazole, 1-cyanoethyl-2-undecylimidazole, 1-cyano-2-phenylimidazole, 1-cyanoethyl-2-undecylimidazole trimellitate, 1-cyanoethyl-2-phenylimidazolium trimellitate, 2,4-diamino-6-[2'-methylimidazolyl-(1')]-ethyl-s-triazine, 2,4-diamino-6-[2'-ethyl-4'-methylimidazolyl-(1')]-ethyl-s-triazine, 2,4-diamino-6-[2'-methylimidazolyl-(1')]-ethyl-s-triazine isocyanuric acid adduct, 2-phenylimidazole isocyanuric acid adduct, 2-phenyl-4,5-dihydroxymethylimidazole, 2-phenyl-4-methyl-5-hydroxymethylimidazole, and adducts of epoxy resins with the above-mentioned imidazoles or polymer-encapsulated imidazoles.

Examples of the organic phosphine include tributylphosphine, methyldiphenylphosphine, triphenylphosphine, diphenylphosphine, and phenylphosphine; examples of the phosphonium salt include tetraphenylphosphonium tetraphenylborate, tetraphenylphosphonium ethyltriphenylborate, and tetrabutylphosphonium tetrabutylborate; and examples of the tetraphenylboron salt include 2-ethyl-4-methylimidazole tetraphenylborate and N-methylmorpholine tetraphenylborate.

These curing agents may be used alone, or two or more thereof may be used in any combination and at any ratio.

When the liquid composition of the present invention contains a curing agent, the content of the curing agent is preferably in the range of 0.8 to 2.0, and more preferably in the range of 0.8 to 1.5 in terms of the equivalent ratio of the epoxy group in the epoxy resin to the functional group in the curing agent [(functional group in curing agent)/(epoxy group in epoxy resin)] when the curing agent is a phenol-based curing agent, an amine-based curing agent, or an acid anhydride-based curing agent because the curing agent is less likely to be affected by the remaining unreacted epoxy group or the remaining functional group of the curing agent.

When the curing agent is an amide-based curing agent, a tertiary amine, imidazole and a derivative thereof, an organic phosphine, a phosphonium salt, a tetraphenylboron salt, an organic acid dihydrazide, a halogenated boron amine complex, a polymercaptan-based curing agent, an isocyanate-based curing agent, or a blocked isocyanate-based curing agent, the curing agent is preferably used in an amount of 0.1 parts by mass or more, and more preferably 0.5 parts by mass or more, with respect to 100 parts by mass of the epoxy resin. On the other hand, it is preferably used in an amount of 20 parts by mass or less, and more preferably 10 parts by mass or less.

In the case of the dicyandiamide compound, the curing agent is preferably used in an amount of 0.1 parts by mass or more, and more preferably 0.5 parts by mass or more, with respect to 100 parts by mass of the epoxy resin. On the other hand, it is preferably used in an amount of 10 parts by mass or less, and more preferably 6 parts by mass or less.

### (Dispersant)

The liquid composition according to the fourth embodiment of the present invention may contain a dispersant in order to enhance the dispersibility of the inorganic filler. The dispersant used in the liquid composition containing a resin and a filler is mainly added to a liquid composition containing a resin and a filler having a large difference in polarity, thereby improving the interface state between the resin and the filler, and improving the compatibility. As a result, effects such as lowering in viscosity, improvement in dispersibility of the filler, and prevention of aggregation and sedimentation of the filler can be exhibited.

In the fourth embodiment, the content of the dispersant is preferably large from the viewpoint of easily uniformly dispersing the inorganic filler in the liquid composition. On the other hand, the content of the dispersant is preferably small from the viewpoint that an increase in the thermal expansion coefficient due to phase separation between the inorganic filler and the epoxy resin is less likely to occur. The content of the dispersant is preferably 0.1% by mass or more and 30% by mass or less and more preferably 0.1% by mass or more and 25% by mass or less with respect to the total amount of the liquid composition because it is easy to fill a narrow space with the liquid composition and to obtain a low thermal expansion coefficient after curing.

### (Reactive Diluent)

The liquid composition of the present invention may contain a reactive diluent. The reactive diluent is not particularly limited as long as it contains at least one monofunctional epoxy compound. The monofunctional epoxy compound is an epoxy compound having one epoxy group, and has been conventionally used as a reactive diluent for adjusting the viscosity of an epoxy resin composition. The monofunctional epoxy compound is roughly classified into an aliphatic monofunctional epoxy compound and an aromatic monofunctional epoxy compound, and is preferably an aromatic monofunctional epoxy compound from the viewpoint of viscosity.

### (Other Additives)

In addition to the above, the liquid composition may appropriately contain other additives selected from a coupling agent, an ultraviolet inhibitor, an antioxidant, a plasticizer, a flame retardant, a colorant, a fluidity improving agent, an anti-foaming agent, and an ion trapping agent.

In the present embodiment, the liquid composition is preferably a solventless liquid composition. By using a solventless liquid composition, it is possible to prevent the occurrence of voids or the like due to volatilization of the solvent when the liquid composition is heated and cured. The solvent is a volatile component, and in the description herein, is a term including water and an organic solvent. The solventless liquid composition does not substantially contain a solvent, and for example, the content of the solvent is preferably less than 3% by mass, more preferably less than 1% by mass, and most preferably 0% by mass with respect to the total amount of the liquid composition.

### (Viscosity of Liquid Composition)

The liquid composition is a composition having fluidity at room temperature (23° C.). The viscosity of the liquid composition according to the fourth embodiment of the present invention is preferably low from the viewpoint that the composition can be easily filled even in a narrow space. On the other hand, the viscosity of the liquid composition is preferably high from the viewpoint that dripping hardly occurs at the time of filling the composition. The viscosity of the liquid composition at 23°C is preferably 0.1 Pa·s or more, more preferably 1 Pa·s or more, still more preferably 5 Pa·s or more, and particularly preferably 10 Pa·s or more. On the other hand, the viscosity of the liquid composition at 23°C is preferably 250 Pa·s or less, more preferably 200 Pa·s or less, still more preferably 150 Pa·s or less, particularly preferably 60 Pa·s or less, and even more preferably 30 Pa·s or less. Further, the viscosity at 23°C is most preferably 1 Pa·s or more and 30 Pa·s or less.

The viscosity of the liquid composition can be measured in the same manner as in the method for measuring the viscosity of the epoxy resin described above. The viscosity of the liquid composition at 23°C used in the present invention may be measured using a B-type rotational viscosimeter, which is one of single cylinder type rotational viscosimeter methods. As the B-type rotational viscosimeter, for example, one described in Examples may be used.

### (Average Thermal Expansion Coefficient)

The average thermal expansion coefficient (CTE1) of a cured product of the liquid composition according to the fourth embodiment of the present invention is preferably low from the viewpoint that the epoxy resin composite material is less likely to be deformed by an ambient temperature environment or heat generation. On the other hand, the average thermal expansion coefficient of the liquid composition is preferably close to that of a surrounding member from the viewpoint that breakage or the like due to a difference in average thermal expansibility between the liquid composition and the surrounding member is less likely to occur. Therefore, when the liquid composition is used as an underfill material or the like in the production of semiconductor devices, the thermal expansion coefficient of the liquid composition is preferably close to the average thermal expansion coefficient of the semiconductor substrate (for example, 3 to 4 ppm/K).

From the above viewpoint, in the liquid composition according to the fourth embodiment of the present invention, the average thermal expansion coefficient (CTE1) of the cured product is preferably 0 ppm/K or more, more preferably 2 ppm/K or more, still more preferably 4 ppm/K or more, and particularly preferably 10 ppm/K or more. On the other hand, it is preferably 200 ppm/K or less, more preferably 100 ppm/K or less, and particularly preferably 30 ppm/K or less.

The average thermal expansion coefficient and the glass transition temperature (Tg) to be described later of the cured product obtained by curing the liquid composition may be obtained by measuring the average thermal expansion coefficient of the epoxy resin composite material (cured product) obtained by curing the liquid composition to have a gel fraction of 80% or more. The average thermal expansion coefficient (CTE1) is obtained from a slope of a tangent line obtained by measuring a temperature change of a change amount of sample lengths at 25 to 100°C by a compression method based on thermomechanical analysis in accordance with JIS K 7197 (2012). Specific measurement conditions of the average thermal expansion coefficient are as described in Examples.

### (Glass Transition Temperature)

The glass transition temperature (Tg) of the epoxy resin composite material obtained as a cured product by curing the liquid composition according to the fourth embodiment of the present invention is not particularly limited. For example, when the underfill material has a high Tg, it is said that the portion sealed with the underfill material has high bump protection at high temperature and excellent thermal cycle resistance, which is preferable (see, for example, JP 2017-110146 A). From such a viewpoint, the cured product of the liquid composition according to the fourth embodiment has a glass transition temperature (Tg) of preferably 50°C or higher, and more preferably 80°C or higher.

**In** addition, when the glass transition temperature is 150°C or lower, warpage at room temperature (23°C) tends to be less likely to increase. Therefore, the glass transition temperature (Tg) is preferably 50 to 150°C, and more preferably 80 to 150°C. It should be noted that the glass transition temperature (Tg) can be measured by a thermomechanical analyzer (TMA). Specifically, the glass transition temperature (Tg) can be measured by a method described in Examples.

### (Method for Producing Liquid Composition)

The liquid composition according to the fourth embodiment of the present invention can be usually obtained by mixing and kneading an epoxy resin, an inorganic filler, and a curing agent, a dispersant, a reactive diluent, and other additive components, which are used as necessary, using a vacuum mixer, a mixing roll, a planetary mixer, or the like, and defoaming the mixture as necessary. The order of blending these components is arbitrary as long as there is no particular problem such as reaction or generation of a precipitate, and any two components or three or more components among the constituent components may be mixed in advance, and then the remaining component or components may be mixed, or all of the components may be mixed at once.

In addition, for example, by using a zeolite having a particle size of 0.05 µm or more and 1 µm or less and an inorganic filler having a particle size of 1 µm or more and less than 50 µm as raw materials for producing a liquid composition, a small particle size zeolite and a large particle size inorganic filler prepared by the above-described method may be contained in the liquid composition, or a small particle size zeolite and a large particle size inorganic filler prepared by another method may be contained in the liquid composition.

### <Epoxy Resin Composite Material>

The epoxy resin composite material according to the fourth embodiment of the present invention can be obtained by curing the above-described liquid composition. The epoxy resin composite material according to the fourth embodiment is an epoxy resin composite material containing an epoxy resin and an inorganic filler, in which the inorganic filler contains a zeolite having a particle size of 0.05 µm or more and 1 µm or less (small particle size zeolite) and an inorganic filler having a particle size of 1 µm or more and less than 50 µm (large particle size inorganic filler). The epoxy resin composite material according to the fourth embodiment contains the small particle size zeolite and the large particle size inorganic filler, and thus can be produced from a liquid composition having a relatively low viscosity while lowering the thermal expansion coefficient.

In the epoxy resin composite material according to the fourth embodiment of the present invention, the epoxy resin and the inorganic filler are as described above. In addition, the epoxy resin composite material may appropriately contain components contained in the liquid composition in addition to the epoxy resin and the inorganic filler. The content of each component in the epoxy resin composite material is as described above except that the total amount of the epoxy resin composite material is used as a reference instead of the total amount of the liquid composition. Further, the epoxy resin composite material is preferably cured to have a gel fraction of 80% or more, and is preferably cured by the curing agent contained in the above-described liquid composition.

From the same viewpoint as described above, the preferred ranges of the average thermal expansion coefficient (CTE1) and the glass transition temperature of the epoxy resin composite material according to the fourth embodiment of the present invention are the same as the preferred ranges when the liquid composition is formed into a cured product. In addition, the average thermal expansion coefficient and the glass transition temperature of the epoxy resin composite material can be measured by the above described measurement method.

### (Method for Producing Epoxy Resin Composite Material)

The epoxy resin composite material can be obtained by curing the liquid composition. The curing is preferably performed by heating. The method for producing the epoxy resin composite material is not particularly limited as long as the epoxy resin composite material exhibits preferable performance, and the method can be appropriately performed using a known method according to the blending component composition of the liquid composition.

The epoxy resin composite material is preferably molded by, for example, filling the liquid composition in a gap between constituent members of various products such as an electronic device and curing the liquid composition. Further, the epoxy resin composite material may be molded by applying the liquid composition to constituent members of various products and curing the liquid composition.

Alternatively, the epoxy resin composite material may be molded by curing the liquid composition in a desired shape, for example, in a state in which the liquid composition is accommodated in a mold. In the production of such a molded body, injection molding, injection compression molding, extrusion molding, or compression molding can be used. In addition, molding, that is, curing of the epoxy resin composite material can be performed under each curing temperature condition. In addition, the epoxy resin composite material can also be obtained by cutting a cured product of the liquid composition into a desired shape.

The heating temperature at the time of thermal curing is affected by the curing agent to be used and is not particularly limited, and is usually 30°C or higher, preferably 50°C or higher, more preferably 60°C or higher, and still more preferably 80°C or higher. On the other hand, the heating temperature is usually 400°C or lower, preferably 350°C or lower, more preferably 300°C or lower, and still more preferably 250°C or lower. When the curing temperature is within the above range, a high-quality resin composite material can be easily obtained in a short time.

### [Fifth Embodiment]

A fifth embodiment of the present invention is an epoxy resin composite material containing a zeolite as an inorganic filler and having a low average thermal expansion coefficient. Hereinafter, the fifth embodiment of the present invention will be described.

To be specific, the epoxy resin composite material according to the fifth embodiment is an epoxy resin composite material containing an epoxy resin and an inorganic filler, and has an average thermal expansion coefficient at 25 to 100°C of 0 ppm/K or more and 200 ppm/K or less, and the inorganic filler contains a zeolite. As described above, the average thermal expansion coefficient is more preferably 2 ppm/K or more, and particularly preferably 4 ppm/K or more, and is more preferably 100 ppm/K or less, and particularly preferably 30 ppm/K or less.

In the fifth embodiment of the present invention, since the inorganic filler contains a zeolite, the average thermal expansion coefficient can be lowered as described above. From such a viewpoint, the content of the zeolite in the fifth embodiment is preferably 20% by mass or more, more preferably 25% by mass or more, still more preferably 30% by mass or more, particularly preferably 40% by mass or more, and most preferably 45% by mass or more with respect to the total amount of the epoxy resin composite material. On the other hand, from the viewpoint of suppressing an increase in the viscosity of the liquid composition for obtaining the epoxy resin composite material, the content is preferably 90% by mass or less, more preferably 80% by mass or less, still more preferably 75% by mass or less, and particularly preferably 70% by mass or less.

In addition, the content of the epoxy resin in the epoxy resin composite material according to the fifth embodiment is preferably 5% by mass or more, and more preferably 10% by mass or more, with respect to the total amount of the epoxy resin composite material, from the viewpoint that the thermal expansion coefficient is easily lowered, and further from the viewpoint that the excellent physical properties of the epoxy resin are easily maintained. On the other hand, it is preferably 50% by mass or less, more preferably 25% by mass or less, and particularly preferably 15% by mass or less.

The fifth embodiment of the present invention also provides a liquid composition for obtaining the epoxy resin composite material. To be specific, the liquid composition according to the fifth embodiment is a liquid composition containing an epoxy resin and an inorganic filler, in which when the composition is formed into a cured product having a gel fraction of 80% or more, the cured product has an average thermal expansion coefficient at 25 to 100°C of 0 ppm/K or more and 200 ppm/K or less, and the inorganic filler contains a zeolite. The method for measuring the average thermal expansion coefficient and the preferable range thereof are the same as those of the epoxy resin composite material described above.

The liquid composition according to the fifth embodiment preferably has a viscosity at 23°C of 0.1 Pa·s or more and 250 Pa·s or less, and more preferably 1 Pa·s or more and 30 Pa·s or less. This makes it possible to reduce the viscosity of the cured product while reducing the thermal expansion coefficient of the cured product. The preferable range of the viscosity of the liquid composition at 23°C is as described in the first embodiment.

In the fifth embodiment, details other than the contents of the epoxy resin and the zeolite are as described in the fourth embodiment. Further, as described above, the inorganic filler according to the fifth embodiment preferably contains a small particle size zeolite, and the content and other details of the small particle size zeolite are the same as those in the fourth embodiment, and thus description thereof will be omitted.

In addition, the inorganic filler may contain an inorganic filler other than a zeolite. Details of the inorganic filler other than a zeolite are the same as those in the fourth embodiment.

Further, as in the fourth embodiment, the liquid composition according to the fifth embodiment preferably contains a curing agent, and may contain a reactive diluent, or other additives, and these components are as described above. In addition, the liquid composition according to the fifth embodiment is also preferably a solventless liquid composition, and the details thereof are as described above.

Further, also in the fifth embodiment, the inorganic filler preferably contains a small particle size zeolite and a large particle size inorganic filler as in the fourth embodiment. In addition, the liquid composition or the epoxy resin composite material in the fifth embodiment may contain a dispersant.

### (Use)

The composition and the resin composite material of the present invention can be used for, for example, a catalyst module, a molecular sieve membrane module, an optical member, a moisture-absorbing member, food, a building member, and a constituent member or a packaging member of an electronic device, and among them, the composition and the resin composite material are preferably used for an electronic device. Therefore, the present invention provides, as a preferred aspect, an electronic device containing a resin composite material, and more preferably, an electronic device containing an epoxy resin composite material.

The electronic device is a device which has two or more electrodes and controls a current flowing between the electrodes or a voltage generated between the electrodes by electricity, light, magnetism, or a chemical substance, or a device which generates light, an electric field, or a magnetic field by an applied voltage or current. Specific examples thereof include a resistor, a rectifier (diode), a switching element (transistor or thyristor), an amplifier element (transistor), a memory element, a chemical sensor, or a device obtained by combining or integrating these elements. Further, a photodiode or a phototransistor which generates a photocurrent, an electroluminescent element which emits light by application of an electric field, and an optical element such as a photoelectric conversion element or a solar cell which generates an electromotive force by light can also be given. The electronic device is preferably a semiconductor device. The semiconductor device preferably includes at least a semiconductor substrate, and examples thereof include a device in which a semiconductor chip is mounted on a substrate and a device in which semiconductor chips or semiconductor substrates are stacked in multiple layers.

The liquid composition of the present invention is preferably used as a liquid sealing agent, and in this case, the epoxy resin composite material formed by curing the liquid composition is preferably used as a sealing material.

The liquid sealing agent is preferably used as a sealing material which fills a gap formed in a constituent member and is then cured to fill the gap.

In addition, the liquid sealing agent may be used as a sealing material for filling a gap between constituent members, for example, by applying the liquid sealing agent onto various constituent members, stacking another constituent member on the liquid sealing agent, and then appropriately curing the liquid sealing agent. At this time, the liquid sealing agent may be appropriately cured to be in a B stage before another constituent member is stacked.

Among these, the liquid composition of the present invention is preferably used for an application in which the composition is filled in a gap and cured. That is, the sealing material is preferably produced by filling the liquid composition of the present invention into a gap and then curing the liquid composition. The liquid composition of the present invention has a low viscosity and can be filled into a narrow gap without causing voids or the like.

The liquid composition of the present invention is preferably used as a liquid sealing agent, and particularly preferably used as an underfill material. The underfill material is preferably used in the production of an electric device, particularly a semiconductor device, and is preferably used for filling a gap formed between a substrate and a semiconductor chip, between substrates, or between semiconductor chips, for example. As the substrate, a known substrate can be used, and a substrate made of an organic material such as an epoxy resin substrate or a phenol resin substrate may be used. In addition, the semiconductor chip may be formed of a semiconductor substrate such as a silicon substrate.

The cured product of the liquid composition of the present invention has a low thermal expansion coefficient, and when the liquid composition is used as an underfill material, the difference in thermal expansion coefficient between the cured product and a semiconductor substrate is reduced, and thus the thermal cycle resistance is improved.

For example, in a laminate in which a semiconductor chip is mounted on a substrate, the underfill material is preferably used as a sealing material that is filled in a gap between the substrate and the semiconductor chip and then cured by heating to seal the gap between the substrate and the chip. In this case, the semiconductor chip may be bonded to the surface of the substrate on which the wiring pattern is formed via a bump by, for example, reflow before the underfill material is filled.

The underfill material may be used in the production of a semiconductor device by a pre-apply method. Specifically, on the surface of a semiconductor chip on which a plurality of bumps are formed, the underfill material is filled between the plurality of bumps to form an underfill layer. Here, the filled underfill material may be B-staged as necessary. Thereafter, the semiconductor chip on which the underfill layer is formed may be placed on the front surface of the substrate such that the surface on which the underfill layer is formed faces the substrate. Next, the underfill layer may be cured by heating and pressing to become a sealing material, and the semiconductor chip may be subjected to bonding on the front surface of the substrate on which the wiring pattern is formed via the bumps.

Further, in the pre-apply method, the underfill material may be applied onto the front surface of the substrate on which the wiring pattern is formed to form the underfill layer. Here, the applied underfill layer may be B-staged as necessary. Thereafter, the semiconductor chip on which the bumps are formed may be placed on the substrate on which the underfill layer is formed such that the surface on which the bumps are formed faces the front surface of the substrate on which the underfill layer is formed. Thereafter, the underfill layer may be cured by heating and pressing to become a sealing material, and the semiconductor chip may be subjected to bonding on the front surface of the substrate on which the wiring pattern is formed via the bumps.

In the above description, an example in which the underfill material is used as a sealing material for filling a gap between a substrate and a semiconductor chip has been described. However, the use of the underfill material is not particularly limited, and the underfill material may be used for filling a gap between semiconductor chips or may be used as a sealing material for filling a gap between substrates. In addition, the substrate is not limited to a substrate made of an organic material, and may be a semiconductor substrate.

### Examples

Hereinafter, the present invention will be further described in detail with reference to Examples, Comparative Examples, and Reference Examples, but the present invention is not limited to the following Examples, Comparative Examples, and Reference Examples as long as the gist of the present invention is not deviated.

### <Synthesis of Zeolite>

### [Example 1]

### (Production of Spherical Zeolite (Zeolite Filler A))

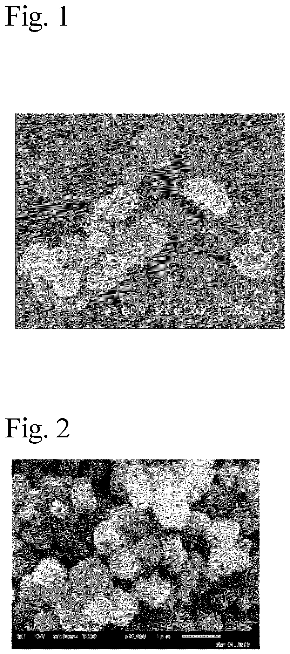

To a container, sodium hydroxide manufactured by Kishida Chemical Co., Ltd., potassium hydroxide manufactured by Kishida Chemical Co., Ltd., N,N,N-trimethyl-1-adamantammonium hydroxide (TMAdaOH) manufactured by SACHEM, Inc. as a structure directing agent (SDA), "KYOWAAD 200S" manufactured by Kyowa Chemical Industry Co., Ltd. as an aluminum hydroxide, "Cataloid SI-30" manufactured by JGC Catalysts and Chemicals Ltd. as a silica, and "KBM-403" manufactured by Shin-Etsu Chemical Co., Ltd. as a silane coupling agent were added in this order. The composition (molar ratio) of the obtained mixture was SiO₂:Al₂O₃:NaOH:KOH:TMAdaOH:H₂O:KBM-403 = 1.0:0.033:0.07:0.06:0.07:20:0.025. With respect to the amount of silica, 2% by mass of seed crystals of CHA-type zeolite was added and thoroughly mixed, and then the obtained mixture was placed in a pressure-resistant container and subjected to hydrothermal synthesis under stirring conditions in an oven at 160°C for 48 hours. The mixture was subjected to suction filtration, washed, and then dried. The obtained powder was fired at 600°C for 6 hours under air flow to remove TMAdaOH as the structure directing agent (SDA), thereby obtaining a CHA-type aluminosilicate zeolite. An SEM photograph of the obtained zeolite is shown in Fig. 1. In the zeolite, the particle size of each particle was within the range of 0.1 µm or more and less than 1.0 µm, and the average primary particle size was 0.5 µm. The average primary particle size was set as an average value of the particle sizes of 50 primary particles selected at random. The obtained zeolite was in the form of spherical particles having a Si/Al₂ ratio of 26.1, a sphericity of 0.88, and a roundness of 0.89, and had a framework density of 14.5 T/1000 Å³, and counter cations of potassium, sodium, and proton type. Table 1 shows the physical properties of zeolite.

### [Comparative Example 1]

### (Production of Cubic Zeolite (Zeolite Filler B))

To a container, sodium hydroxide manufactured by Kishida Chemical Co., Ltd., potassium hydroxide manufactured by Kishida Chemical Co., Ltd., N,N,N-trimethyl-1-adamantammonium hydroxide (TMAdaOH) manufactured by SACHEM, Inc. as a structure directing agent (SDA), "KYOWAAD 200S" manufactured by Kyowa Chemical Industry Co., Ltd. as an aluminum hydroxide, and "Cataloid SI-30" manufactured by JGC Catalysts and Chemicals Ltd. as a silica were added in this order. The composition (molar ratio) of the obtained mixture was SiO₂:Al₂O₃:NaOH:KOH:TMAdaOH:H₂O = 1.0:0.033:0.07:0.06:0.07:20. With respect to the amount of silica, 2% by mass of seed crystals of CHA-type zeolite was added and thoroughly mixed, and then the obtained mixture was placed in a pressure-resistant container and subjected to hydrothermal synthesis under stirring conditions in an oven at 160°C for 48 hours. The mixture was subjected to suction filtration, washed, and then dried. The obtained powder was fired at 600°C for 6 hours under air flow to remove TMAdaOH as the structure directing agent (SDA), thereby obtaining a CHA-type aluminosilicate zeolite. An SEM photograph of the obtained zeolite is shown in Fig. 2. In the zeolite, the particle size of each particle was within the range of 1.0 µm or more and 10 µm or less, and the average primary particle size was 0.5 µm. The average primary particle size was set as an average value of the particle sizes of 50 primary particles selected at random. The obtained zeolite had a Si/Al₂ ratio of 24.2, a sphericity of 0.60, a roundness of 0.79, a framework density of 14.5 T/1000 Å³, and counter cations of potassium, sodium, and proton type. Table 1 shows the physical properties of zeolite.

**Table 1**

| | Silane coupling agent | Si/Al₂ ratio | Average primary particle size | Sphericity | Roundness |
|---|---|---|---|---|---|
| Example 1 | presence | 26.1 | 0.5 µm | 0.88 | 0.89 |
| Comparative Example 1 | absence | 24.2 | 0.5 µm | 0.68 | 0.79 |

From the results shown in Table 1, it was confirmed that the zeolite according to the first embodiment of the present invention can be produced by the production method of the present invention. On the other hand, from Comparative Example 1, it was found that when the zeolite was produced without using a silane coupling agent, a zeolite having a cubic shape with a small sphericity and a small roundness was produced. It can be seen from the SEM image shown in Fig. 2 that the zeolite produced in Comparative Example 1 has a cubic shape.

Next, examples of the composition and the resin composite material of the present invention will be described.

### <Blended Components>

Components used in the preparation of the liquid composition and the resin composite material are as follows.

### <Inorganic Filler>

As zeolite fillers A and B, the zeolite fillers A and B produced in Example 1 and Comparative Example 1 described above were used, respectively.

The inorganic filler other than the zeolite fillers A and B is as follows.

Silica filler A: product name "FE920A-SQ" manufactured by Admatechs Company Limited (average particle size: 4 µm, true spherical silica filler).

### <Epoxy Resin>

Product name "jER630" manufactured by Mitsubishi Chemical Corporation (p-aminophenol type epoxy resin, epoxy equivalent: 97 g/equivalent).

### <Polyimide Powder>

Product name "UIP-R" manufactured by Ube Industries, Ltd. (polyimide, average particle size: 7 µm, specific weight: 1.39).

### <Curing Agent>

Acid anhydride-based curing agent: product name "HN-2200" (methyltetrahydrophthalic anhydride, amine equivalent: 83 g/equivalent) manufactured by Hitachi Chemical Company, Ltd.

### (Physical Property Evaluation)

The physical property evaluation was performed as follows.

### (Gel Fraction)

The gel fraction of the resin composite material was measured by the following procedure.

After the heat treatment at 80°C for 2 hours, the resin composite material prepared under the curing conditions at 120°C for 2 hours was cut out in the range of 0.5 to 0.6 g, and placed on a wire net. The wire net was allowed to stand for 24 hours in a state of being immersed in acetone. Thereafter, the wire net was taken out from the acetone, and was subjected to vacuum drying. The ratio of the weight of the resin composite material after immersion in acetone to the weight before immersion was defined as the gel fraction.

### (Viscosity of Liquid Composition)

The viscosity of the liquid composition at 23°C was measured using a B-type rotational viscosimeter. As the B-type rotational viscosimeter, "LVDV-1 Pri" manufactured by Brookfield Engineering Laboratories, Inc., spindle: S64 or S63 was used when the viscosity was 0.1 to 100 Pa·s, and "HBDV-E" manufactured by Brookfield Engineering Laboratories, Inc., spindle: S-07 was used when the viscosity was more than 100 Pa·s. The value measured at 20 rpm was taken as a representative value of the viscosity of each sample.

### (Average Thermal Expansion Coefficient (CTE1) of Epoxy Resin and Epoxy Resin Composite Material)

The average thermal expansion coefficient of the epoxy resin composite material obtained by curing the liquid composition to have a gel fraction of 80% or more was measured by thermomechanical analysis according to a method in accordance with JIS K 7197 (2012). The average thermal expansion coefficient was measured by a compression method using a thermomechanical analyzer (apparatus name: TMA SS7100, manufactured by SII Nanotechnology Inc.).

To be specific, the epoxy resin composite material was cut out into a size of ϕ 6 mm × 10 mm, and subjected to temperature drop measurement at 5°C/min from 200°C to 20°C by a compression method using the thermomechanical analyzer. The temperature change of the amount of change in sample lengths at 25 to 100°C was measured, and the slope of the tangent line was defined as the average thermal expansion coefficient (CTE1).

### (Average Thermal Expansion Coefficient (CTE1) of Polyimide Resin and Polyimide Resin Composite Material)

The average thermal expansion coefficient of the polyimide resin composite obtained by curing the liquid composition to have a gel fraction of 80% or more was measured by thermomechanical analysis according to a method in accordance with JIS K 7197 (2012). The average thermal expansion coefficient was measured by a compression method using a thermomechanical analyzer (apparatus name: TMA SS7100, manufactured by SII Nanotechnology Inc.). To be specific, the polyimide resin composite material was cut out into a size of 10 mm in lateral width, 6 mm in thickness, and 10 mm in height, and subjected to temperature drop measurement at 5°C/min from 200°C to 20°C by a compression method using a thermomechanical analyzer. The temperature change of the amount of change in sample lengths at 25 to 100°C was measured, and the slope of the tangent line was defined as the average thermal expansion coefficient (CTE1).

### (Glass Transition Temperature of Epoxy Resin Composite Material)

The glass transition temperature (Tg) of the epoxy resin composite material obtained by curing the liquid composition to have a gel fraction of 80% or more was measured by a thermomechanical analyzer (TMA). Specifically, the measurement was performed with the same apparatus and under the same conditions as in the evaluation of the thermal expansion coefficient, and a graph in which the temperature is the X axis and the linear expansion coefficient is the Y axis was created. CTE' 1 was determined from the slope of the tangent line at 15 to 75°C in this graph, CTE' 2 was determined from the slope of the tangent line at 150 to 200°C, and the glass transition temperature Tg (°C) was determined from the intersection of CTE' 1 and CTE' 2.

### [Example 2]

In a cup, 16 g of the epoxy resin, 24 g of the curing agent, and 60 g of the zeolite filler A were weighed and mixed so as to obtain the mix proportion shown in Table 2. Thereafter, the mixture was mixed at 1500 rpm for 5 minutes using a vacuum mixer ("V-mini 300" manufactured by EME Corporation) to prepare a liquid composition. The viscosity of this liquid composition at 23°C was measured with a rotational viscosimeter. Thereafter, the liquid composition was cast into a mold and heated at 80°C for 2 hours, and then heated at 120°C for 2 hours to be cured to have a gel fraction of 80% or more, and then removed from the mold to obtain an epoxy resin composite material.

### [Comparative Example 2]

In a cup, 16 g of the epoxy resin, 24 g of the curing agent, and 60 g of the zeolite filler B were weighed and mixed so as to obtain the mix proportion shown in Table 2. A liquid composition and a resin composite material thereof were obtained in the same manner as in Example 2 except for the blending ratio.

### [Example 3]

In a cup, 16 g of the epoxy resin, 24 g of the curing agent, 20 g of the zeolite filler A, and 40 g of the silica filler were weighed and mixed so as to obtain the mix proportion shown in Table 2. A liquid composition and a resin composite material thereof were obtained in the same manner as in Example 2 except for the blending ratio.

### [Comparative Example 3]

In a cup, 16 g of the epoxy resin, 24 g of the curing agent, and 60 g of the silica filler were weighed and mixed so as to obtain the mix proportion shown in Table 2. A liquid composition and a resin composite material thereof were obtained in the same manner as in Example 2 except for the blending ratio.

### [Comparative Example 4]

A liquid composition and a resin composite material thereof were obtained in the same manner as in Example 2 except that a zeolite filler was not used in Example 2.

The viscosity of each liquid composition in Examples 2 and 3 and Comparative Examples 2 to 4 was measured, and the average thermal expansion coefficient (CTE1) and the glass transition temperature Tg of the epoxy resin composite material were measured. The results are shown in Table 2.

**Table 2**

| | | Example 2 | Comparative Example 2 | Example 3 | Comparative Example 3 | Comparative Example 4 |
|---|---|---|---|---|---|---|
| Mix proportion of liquid composition (% by mass) | Zeolite filler A | 60 | 0 | 20 | 0 | 0 |
| | Zeolite filler B | 0 | 60 | 0 | 0 | 0 |
| | Silica filler | 0 | 0 | 40 | 60 | 0 |
| | Epoxy resin | 16 | 16 | 16 | 16 | 16 |
| | Curing agent | 24 | 24 | 24 | 24 | 24 |
| Physical properties | CTE1 (ppm/K) | 20 | - | 26 | 31 | 64 |
| | Viscosity (Pa·s) | 380 | 520 | 48 | 20 | 0.4 |

From the results of Examples 2 and 3, it was confirmed that by containing the zeolite according to the present invention, a liquid composition having a low viscosity can be obtained, and the thermal expansion coefficient of a resin composite material obtained by curing the liquid composition can be lowered.

That is, it was confirmed that by containing the zeolite according to the present invention, a liquid composition having a low viscosity can be obtained, and the thermal expansion coefficient of a resin composite material obtained by curing the liquid composition can be lowered.

Further, from Example 3, it was confirmed that the liquid composition obtained by using the small particle size zeolite and the large particle size inorganic filler in combination had a low viscosity as a liquid composition, but an epoxy resin composite material having a low thermal expansion coefficient was obtained by curing the liquid composition. On the other hand, the resin composite material of Comparative Example 2 had a high thermal expansion coefficient in spite of containing the same amount of the filler. That is, it was confirmed that a liquid composition having a low viscosity could be obtained by using the small particle size zeolite and the large particle size inorganic filler in combination, and the thermal expansion coefficient of the resin composite material obtained by curing the liquid composition could be lowered.

### [Example 4]

In a cup, 21 g of polyimide powder and 9 g of the zeolite filler A produced in Example 1 were weighed, mixed, and then spread in a press mold. The mold was set in a high-temperature vacuum press apparatus (manufactured by Kitagawa Seiki Co., Ltd.), and pressing was performed at a press temperature of 390°C and a press surface pressure of 8 MPa for 30 minutes, followed by demolding, thereby obtaining a molded body having a length of 11 cm, a width of 2.5 cm, and a thickness of 6 mm.

### [Example 5]

In a cup, 21 g of polyimide powder and 9 g of silica filler were weighed, mixed, and spread in a press mold, and then a molded body was obtained in the same manner as in Example 4.

### [Comparative Example 5]

A molded body was produced in the same manner as in Example 4 except that the zeolite filler A was not used, and the average thermal expansion coefficient thereof was measured. The results are shown in Table 3.

**Table 3**

| | | Example 4 | Example 5 | Comparative Example 5 |
|---|---|---|---|---|
| Mix proportion of resin composition (% by mass) | Zeolite filler A | 30 | 0 | 0 |
| | Silica filler | 0 | 30 | 0 |
| | Polyimide resin | 70 | 70 | 100 |
| Physical properties | CTE1 (ppm/K) | 26 | 31 | 41 |

### [Example 6] (Evaluation of injectability)

**In** a cup, 2.4 g of the epoxy resin, 3.6 g of the curing agent, and 4 g of the zeolite filler A were weighed and mixed so as to obtain the mix proportion shown in Table 3. Thereafter, the mixture was mixed at 1500 rpm for 5 minutes using a vacuum mixer ("V-mini 300" manufactured by EME Corporation) to prepare a liquid composition. A gap of 6 µm was provided on a glass plate, and a test piece in which the glass plate was fixed instead of the semiconductor element was prepared. The test piece was placed on a hot plate set at 80°C, and after confirming that the temperature of the glass plate reached 80°C, the prepared liquid composition was applied to one end of the glass plate, and the distance of movement after a certain period of time was measured. This procedure was performed twice, and the average value of the measured values was taken as the measured value of the distance of movement.

In addition, when the liquid composition is injected into a narrow gap, in the case where the particle size of the filler is large with respect to the gap, the filler may be left behind and only the resin may be filled. In this case, since a resin-rich portion is formed, a change in the color of the liquid composition can be visually confirmed. In the present liquid resin composition, since the zeolite filler is white and the resin component is transparent, the resin-rich portion is nearly transparent. When there is a change in color, it can be determined that the gap has not been filled with the filler, and when there is no change in color, it can be determined that the gap has been filled with the filler. Therefore, evaluation was made according to the following criteria. The evaluation results are shown in Table 3.
C: There was a change in color.
A: There was no change in color.

### [Comparative Example 6]

In a cup, 2 g of the epoxy resin, 3 g of the curing agent, and 5 g of the zeolite filler C (large particle size CHA) were weighed and mixed so as to obtain the mix proportion shown in Table 3. A liquid composition having a viscosity equivalent to that of Example 6 was obtained in the same manner as in Example 6 except for the blending ratio, and the distance of movement was measured. In addition, the color of the liquid composition filled in the gap was compared with the color of the liquid composition before filling to confirm whether or not there was a change in color, and the filler filling in the gap was evaluated in the same manner as in Example 6. The evaluation results are shown in Table 3.

**Table 4**

| | Component | Example 6 | Comparative Example 6 |
|---|---|---|---|
| Mix proportion of resin composition (% by mass) | Zeolite filler A | 40 | 0 |
| | Zeolite filler C | 0 | 50 |
| | Epoxy resin | 24 | 20 |
| | Curing agent | 36 | 30 |
| Physical properties | Liquid composition viscosity (Pa·s) | 30 | 30 |
| | Distance of movement (mm) after 5 minutes | 40 | 15 |
| | Filler filling in gap | A | C |

From the results of Table 4, it is understood that the zeolite filler A having a small particle size is better in the injectability into the narrow gap.

In the future, miniaturization of devices and miniaturization of members constituting the devices are expected to progress, and miniaturization, thinning, and 3D stacking of semiconductors chips are also expected to progress. In such an application, it is considered that mounting at a narrow gap of about 25 µm or 10 µm, which is narrower than the current narrow gap of about 50 µm, is required.

The filler having a small particle shape and a spherical shape and having a high negative expansion characteristic as in the present application can also be used for the above-described applications.

### Industrial Applicability

According to the present invention, it is possible to provide a liquid composition having a low viscosity. In addition, it is possible to provide a resin composite material having a low thermal expansion coefficient by curing the liquid composition. That is, according to the composition of the present invention, it is possible to obtain a sealing material having excellent injectability and excellent heat resistance, and the composition of the present invention is particularly useful as an underfill material.

In addition, the resin composite material having a low thermal expansion coefficient of the present invention is also useful as a sealing material produced by press molding.

## Claims

1. A zeolite which is a spherical aluminosilicate having a particle size of 0.05 µm or more and less than 1.0 µm and having d6r as CBU.

2. The zeolite according to claim 1, having a sphericity of 0.7 or more.

3. The zeolite according to claim 2, which is a CHA-type zeolite.

4. A composition comprising the zeolite according to claim 3 and a resin.

5. The composition according to claim 4, wherein the resin is at least one selected from the group consisting of an epoxy resin and a polyimide resin.

6. The composition according to claim 5, further comprising an inorganic filler having a particle size of 1.0 µm or more and 10 µm or less.

7. The composition according to claim 5, wherein a content of the zeolite according to claim 1 in all the fillers is 90% by mass or more.

8. The composition according to claim 5, wherein the content of the zeolite is 40 to 70% by mass, the resin is an epoxy resin, and the composition has a viscosity at 23°C of 0.1 Pa·s or more and 250 Pa·s or less.

9. A resin composite material comprising the composition according to claim 5, wherein the content of the zeolite is 40 to 70% by mass, the resin is an epoxy resin, and an average thermal expansion coefficient at 25 to 100°C is 10 to 30 ppm/K.

10. A liquid sealing agent comprising the composition according to claim 5.

11. A sealing material comprising the resin composite material according to claim 9.

12. An electronic device comprising the resin composite material according to claim 9.

13. A method for producing a sealing material, comprising a step of filling a gap with the composition according to claim 8 and then curing the composition.

14. A method for producing a zeolite, comprising a step of hydrothermally synthesizing a raw material composition containing a silicon atom raw material, a water-soluble aluminum atom raw material, an organic structure directing agent, a silane coupling agent, and water.

15. The method for producing a zeolite according to claim 14, further comprising a firing step.
